Europäisches Patentamt

European Patent Office

Office européen des brevets

(19)

(11) **EP 0 636 258 B1**

(12) **EUROPÄISCHE PATENTSCHRIFT**

(45) Veröffentlichungstag und Bekanntmachung des Hinweises auf die Patenterteilung:
**27.03.1996 Patentblatt 1996/13**

(21) Anmeldenummer: **92908874.8**

(22) Anmeldetag: **16.04.1992**

(51) Int Cl.6: **G06F 11/16**, G11C 29/00

(86) Internationale Anmeldenummer:
**PCT/DE92/00316**

(87) Internationale Veröffentlichungsnummer:
**WO 93/21578 (28.10.1993 Gazette 1993/26)**

(54) **INTEGRIERTER HALBLEITERSPEICHER MIT REDUNDANZEINRICHTUNG**

INTEGRATED SEMICONDUCTOR MEMORY WITH REDUNDANCY ARRANGEMENT

MEMOIRE A SEMI-CONDUCTEURS INTEGRE A REDONDANCE

(84) Benannte Vertragsstaaten:
**AT DE FR GB IT NL**

(43) Veröffentlichungstag der Anmeldung:
**01.02.1995 Patentblatt 1995/05**

(73) Patentinhaber: **SIEMENS AKTIENGESELLSCHAFT**
**D-80333 München (DE)**

(72) Erfinder:
• **RIEGER, Johann**
  **D-93077 Bad Abbach (DE)**
• **STECKER, Johannes**
  **D-80992 München 50 (DE)**

(56) Entgegenhaltungen:
**WO-A-91/14227**     **US-A- 4 538 247**
**US-A- 4 752 914**

**Beschreibung**

Integrierter Halbleiterspeicher mit Redundanzeinrichtung

Die Erfindung betrifft einen integrierten Halbleiterspeicher mit einer Redundanzeinrichtung nach dem Oberbegriff des Patentanspruches 1.

Bei modernen integrierten Halbleiterspeichern sind die Speicherzellen in mehreren Speicherfeldblockeinheiten von einem bis mehreren Speicherfeldblöcken angeordnet. Im Betrieb wird aus Gründen der Strom- und Zeitersparnis in Abhängigkeit von Adreßsignalen jeweils nur eine Speicherfeldblockeinheit aktiviert. Zur Erhöhung der Ausbeute bei der Herstellung dieser Halbleiterspeicher ist es seit langem bekannt, sogenannte redundante Wortleitungen mit redundanten Speicherzellen entlang der redundanten Wortleitungen vorzusehen (siehe z.B. WO 91/14227). Speicher mit mehreren Speicherfeldblockeinheiten weisen demzufolge in den Speicherfeldblockeinheiten über die normalen Wortleitungen mit normalen Speicherzellen hinaus noch ein bis beispielsweise acht oder sechzehn redundante Wortleitungen mit redundanten Speicherzellen auf. Die redundanten Wortleitungen werden beim Betrieb im Bedarfsfall, das heißt, wenn redundante Speicherzellen defekte normale Speicherzellen ersetzen sollen ("Redundanzfall"), anstelle der normalen Wortleitungen angesteuert. Dies erfolgt bekanntlich über sogenannte Redundanzdecoder, die auf die Adresse der jeweiligen normalen Wort leitung mit den zu ersetzenden defekten Speicherzellen programmierbar sind (Das Programmieren geschieht bekanntlich über sogenannte Fuses, die mittels elektrischen Stromes oder mittels eines Laserstrahls unterbrechbar sind).

Zur Erhöhung der Effektivität solcher Redundanzmaßnahmen sind in IEEE Journal of Solid-State Circuits, Vol. 26, No. 1, Jan. 1991, Seiten 12 bis 17, "A Flexible Redundancy Technique for High-Density DRAM's" verschiedene Redundanz-Architekturen vorgestellt. Allen Architekturen ist gemeinsam, daß in jeder einzelnen Speicherfeldblockeinheit nur maximal so viele Normalwortleitungen durch Redundanzwortleitungen ersetzbar sind, wie es der Anzahl der Redundanzwortleitungen einer solchen Speicherfeldblockeinheit entspricht. Dies kann nun in der Praxis dazu führen, daß ein solcher Halbleiterspeicher in einer Speicherfeldblockeinheit mehr Normalwortleitungen mit defektbehafteten Speicherzellen enthält als in eben derselben Speicherfeldblockeinheit Redundanzwortleitungen mit entsprechenden Redundanzspeicherzellen vorhanden sind. Ein solcher Speicher ist dann mit Hilfe der bislang bekannten Redundanz-Architekturen nicht "reparierbar", obwohl in anderen Speicherfeldblockeinheiten als der betrachteten Speicherfeldblockeinheit evtl. noch genügend Redundanzwortleitungen mit Redundanzspeicherzellen vorhanden sind, die in diesen anderen Speicherfeldblockeinheiten nicht benutzt werden.

Aufgabe der vorliegenden Erfindung ist es, einen integrierten Halbleiterspeicher mit Redundanzeinrichtung zu schaffen, die im Bedarfsfall, das heißt bei Vorliegen von Normalwortleitungen mit defektbehafteten Speicherzellen, eine bessere Ausnutzung der Redundanzeinrichtung ermöglicht.

Diese Aufgabe wird bei einem gattungsgemäßen Halbleiterspeicher gelöst mit den kennzeichnenden Merkmalen des Patentanspruches 1. Vorteilhafte Aus- und Weiterbildungen sind in Unteransprüchen gekennzeichnet.

Nachstehend wird die Erfindung anhand der Zeichnung näher beschrieben. Es zeigen:

Die Figuren 1 bis 5          verschiedene Ausführungsformen der Erfindung im Überblick,
die Figuren 6 bis 13        vorteilhafte Einzelheiten der Erfindung.

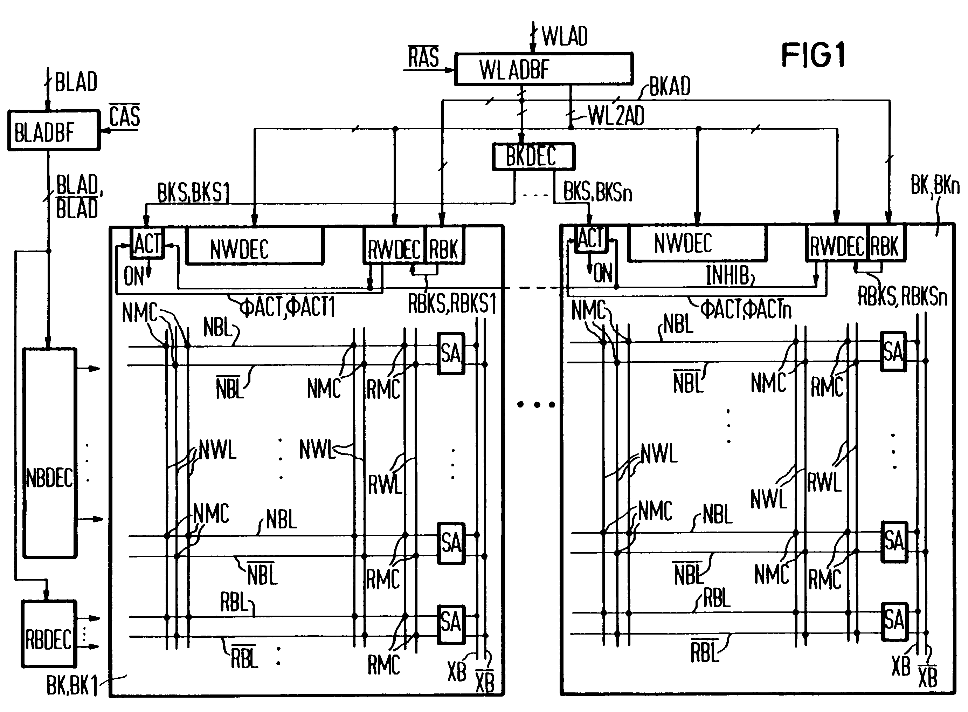

Die Figuren 1 bis 5 zeigen, stark schematisiert dargestellt, verschiedene Ausführungsformen des erfindungsgemäßen Halbleiterspeichers einschließlich einiger bereits bekannter Schaltungsteile, die zwar von der Erfindung nicht unmittelbar betroffen sind, die jedoch das Verständnis erleichtern. Soweit von aktivierten Signalen bzw. Signalen im aktivierten Zustand gesprochen wird, sollen diese Signale den Zustand "log. 1" aufweisen, ansonsten den Zustand "log. 0". Dies entspricht der sogenannten positiven Logik und dient lediglich einer einfacheren Darstellungsweise. Andere Logikvereinbarungen sind selbstverständlich möglich. Die dargestellten Halbleiterspeicher enthalten mehrere Speicherfeldblockeinheiten BK (dargestellt sind aus Gründen der Übersichtlichkeit jeweils lediglich zwei Speicherfeldblockeinheiten BK) mit darin enthaltenen Speicherzellen. Unter einer Speicherfeldblockeinheit BK wird dabei verstanden eine Einheit mit einem oder mehreren Arrays von Speicherzellen (das heißt Speicherfeldblöcken), die unabhängig von weiteren solchen Einheiten aktivierbar und betreibbar ist. Die Speicherzellen sind begrifflich eingeteilt in Normalspeicherzellen NMC und in Redundanzspeicherzellen RMC. Unter Normalspeicherzellen NMC werden dabei solche Speicherzellen verstanden, deren Adressierung und Betrieb ohne Zuhilfenahme von irgendwelchen Redundanzschaltungsmitteln erfolgen kann. Unter Redundanzspeicherzellen RMC werden solche Speicherzellen verstanden, die verwendbar sind, um mit Fehlern behaftete Speicherzellen (meist Normalspeicherzellen NMC) zu ersetzen, wobei der Fehler sowohl in den zu ersetzenden Speicherzellen selbst oder im Zusammenhang mit deren Betrieb auftreten kann, beispielsweise Fehler bei den zugeordneten Bitleitungen, Wortleitungen, Leseverstärkern, Adreßdecodern. Die Technik der Verwendung redundanter Speicherzellen anstelle von fehler-behafteten Speicherzellen ist allgemein bekannt.

Die Normalspeicherzellen NMC sind angeordnet entlang (und somit adressierbar über) Normalwortleitungen NWL sowie entlang von Normalbitleitungen, wobei jede Normalbitleitung üblicherweise zwei Hälften NBL, $\overline{\text{NBL}}$ enthält. An die Normalbitleitungen NBL, NBL sind allgemein bekannte Leseverstärker SA angeschlossen.

Die Redundanzspeicherzellen RMC sind angeordnet entlang (und somit adressierbar über) Redundanzwortleitungen RWL und Normalbitleitungen NBL, $\overline{\text{NBL}}$ sowie entlang von Normalwortleitungen NWL und Redundanzbitleitungen RBL, $\overline{\text{RBL}}$ und entlang von Redundanzwortleitungen RWL und Redundanzbitleitungen RBL, $\overline{\text{RBL}}$. Für die vorliegende Erfindung von Interesse sind in erster Linie die Anordnungen entlang der Redundanzwortleitungen RWL.

Die Speicherzellen NMC, RMC sind über die jeweils zugehörigen Normalbitleitungen NBL, $\overline{\text{NBL}}$, die Redundanzbitleitungen RBL, $\overline{\text{RBL}}$, die Normalwortleitungen NWL und die Redundanzwortleitungen RWL adressierbar mittels an den Halbleiterspeicher anlegbaren Adressignalen, typischerweise im allgemein bekannten Adreßmulitplexverfahren. Dabei werden zu einem ersten Zeitpunkt die für Wortleitungsadressierung zuständigen Wortleitungsadressignale WLAD, gesteuert durch ein Taktsignal $\overline{\text{RAS}}$, in einem Wortleitungsadreßpuffer WLADBF zwischengespeichert. Entsprechend werden zu einem zweiten Zeitpunkt die für Bitleitungsadressierung zuständigen Bitleitungsadressignal BLAD, gesteuert durch ein Taktsignal $\overline{\text{CAS}}$, in einem Bitleitungsadreßpuffer BLADBF zwischengespeichert. An den Ausgängen der Adreßpuffer erscheinen diese Adressignale dann in True- und Complementform WLAD, $\overline{\text{WLAD}}$, BLAD, $\overline{\text{BLAD}}$.

Im Betrieb werden bei solchen Halbleiterspeichern, wie bereits geschildert, nicht sämtliche Speicherfeldblockeinheiten BK gleichzeitig aktiviert und betrieben, sondern jeweils nur eine Speicherfeldblockeinheit BK. Dies ist auch beim erfindungsgemäßen Halbleiterspeicher der Fall: Zu diesem Zweck ist jede Speicherfeldblockeinheit BK mittels eines der jeweiligen Speicherfeldblockeinheit BK zugeordneten Blockauswahlsignals BKS auswählbar. Die Auswahl erfolgt mittels eines Blockdecoders BKDEC, gesteuert durch einen ersten Teil BKAD der Wortleitungsadressignale WLAD (und der dazu komplementären Signale $\overline{\text{WLAD}}$).

Die Speicherfeldblockeinheiten BK enthalten Normalwortleitungsdecoder NWDEC und Redundanzwortleitungsdecoder RWDEC zur Auswahl der Normalwortleitungen NWL und der Redundanzwortleitungen RWL. Die Auswahl einer Normalwortleitung NWL bzw. einer Redundanzwortleitung RWL erfolgt innerhalb einer ausgewählten Speicherfeldblockeinheit BK in Abhängigkeit von einem zweiten Teil WL2AD der Wortleitungsadressignale WLAD, $\overline{\text{WLAD}}$.

Entsprechend erhält der Halbleiterspeicher auch Normalbitleitungsdecoder NBDEC und Redundanzbitleitungsdecoder RBDEC zur Auswahl der Normalbitleitungen NBL, $\overline{\text{NBL}}$ und der Redundanzbitleitungen RBL, $\overline{\text{RBL}}$, was ebenfalls allgemein üblich ist. Die Auswahl erfolgt mittels der Bitleitungsadressignale BLAD, $\overline{\text{BLAD}}$.

Die Redundanzwortleitungsdecoder RWDEC und die Redundanzbitleitungsdecoder RBDEC sind, wie allgemein bekannt, über sogenannte Fuses beispielsweise mittels Laserstrahlen oder Strom programmierbar. Die Redundanzspeicherzellen RMC sind somit dann adressierbar zum Ersetzen entsprechender Normalspeicherzellen NMC, wenn der jeweils zugehörige Decoder RWDEC (für Redundanzwortleitungen) und/oder RBDEC (für Redundanzbitleitungen) auf die entsprechende Adreßkombination programmiert ist. Im Hinblick auf die vorliegende Erfindung werden bei der nachstehenden Beschreibung diejenigen Redundanzspeicherzellen RMC, die entlang von Normalwortleitungen NWL angeordnet sind, gleich behandelt wie Normalspeicherzellen NMC, da sie von der Erfindung aufgrund ihrer Anbindung an Normalwortleitungen NWL in derselben Weise betroffen sind wie die Normalspeicherzellen NMC, so daß sich insoweit keine Unterschied im Hinblick auf die Erfindung ergibt.

Erfindungsgemäß enthält nun ein solcher Halbleiterspeicher in der Ausführungsform nach Figur 1 in jeder Speicherfeldblockeinheit BK beispielsweise ebenfalls über Fuses programmierbare Redundanzblockdecoder RBK, mittels deren im programmierten Zustand die jeweilige Speicherfeldblockeinheit BK auswählbar und aktivierbar ist. Damit sind dann auch die in der jeweiligen Speicherfeldblockeinheit BK enthaltenen Redundanzwortleitungsdecoder RWDEC auswählbar. Die Ansteuerung der Redundanzblockdecoder RBK erfolgt, wie beim Blockdecoder BKDEC, mittels des ersten Teils BKAD der Wortleitungsadreßsignale WLAD, $\overline{\text{WLAD}}$. Ein programmierter Redundanzblockdecoder RBK erzeugt dann beim Anlegen einer der Programmierung entsprechenden Kombination der Signale des ersten Teils BKAD der Wortleitungsadressignale WLAD, $\overline{\text{WLAD}}$ ein der jeweiligen Speicherfeldblockeinheit BK entsprechendes Redundanzblockauswahlsignal RBKS, welches den Redundanzwortleitungsdecodern RWDEC der jeweiligen Speicherfeldblockeinheit BK zugeführt wird.

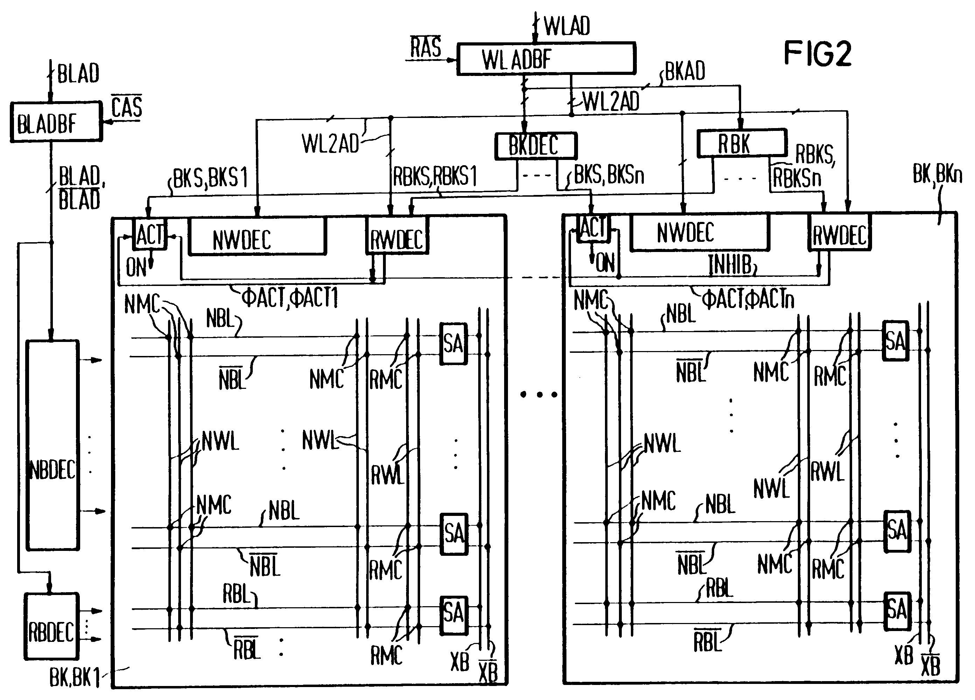

In Figur 1 enthält jede Speicherfeldblockeinheit BK einen solchen programmierbaren Redundanzblockdecoder RBK. Es ist jedoch auch möglich, für den gesamten Halbleiterspeicher gemeinsam einen programmierbaren Redundanzblockdecoder RBK vorzusehen mit entsprechenden Redundanzblockauswahlsignalen RBKS, von denen jedes einer jeweiligen Speicherfeldblockeinheit BK zuführbar ist. Dies ist in der Ausführungsform nach Figur 2 schematisch dargestellt. Figur 2 wird später noch beschrieben.

In der Ausführungsform nach Figur 1 ist jeder programmierbare Redundanzblockdecoder RBK ein Decoder, welcher im programmierten Zustand aus dem ersten Teil BKAD der Wortleitungsadreßsignale WLAD dann ein Redundanzblockauswahlsignal RBKS mit aktiviertem Zustand generiert, wenn der erste Teil BKAD der Wortleitungsadressignale WLAD derjenigen Speicherfeldblockeinheit BK entspricht, welche die Normalwortleitungen NWL mit zu ersetzenden Speicherzellen enthält.

In der Ausführungsform nach Figur 2 hingegen enthält der gemeinsame Redundanzblockauswahldecoder RBK mehrere unabhängig voneinander programmierbare Decoder für Redundanzblockauswahlsignale RBKS. Jeder der Decoder ist dabei bezüglich einer der Speicherfeldblockeinheiten BK programmierbar, so daß im programmierten Zustand das bei entsprechender Adressierung entsprechende Redundanzblockauswahlsignal RBKS in aktiviertem Zustand entsteht.

Vom Stand der Technik her bereits bekannte Blockauswahlsignale BKS dienen bekanntlich dazu, daß sie in aktiviertem Zustand die ihnen zugeordneten Speicherfeldblockeinheiten BK aktivieren, so daß eine solche aktivierte Einheit betreibbar ist. Zu diesem Zweck sind in jeder Speicherfeldblockeinheit BK Aktivierungseinrichtungen ACT vorhanden, die zu aktiverende Schaltungsteile aktivieren wie z.B. den Wortleitungsdecodern nachgeschaltete Wortleitungstreiber WLDVR (aus Gründen der Übersichtlichkeit nicht dargestellt), Precharge-Einrichtungen zum Vorladen der Bitleitungen NBL, $\overline{NBL}$, RBL, $\overline{RBL}$, Signale und Signalgeneratoren zum Steuern der Leseverstärker SA und ähnliches. Diese aktivierende Wirkung der Aktivierungseinheiten ACT ist in den Figuren 1 bis 5 durch ein eingezeichnetes Signal ON pauschal dargestellt.

Der erfindungsgemäße Halbleiterspeicher weist nun ein allen Speicherfeldblockeinheiten BK gemeinsames InhibitSignal INHIB auf, das immer dann, wenn in einer beliebigen Speicherfeldblockeinheit BK irgendeiner der jeweiligen programmierten Redundanzwortleitungsdecoder RWDEC aufgrund des an ihn angelegten zweiten Teils WL2AD der Wortleitungsadressignale WLAD und des aktivierten Redundanzblockauswahlsignals RBKS des ihm zugeordneten Redundanzblockdecoders RBK eine Redundanzwortleitung RWL auswählt. Das Inhibitsignal INHIB ist also stets dann im gesamten Halbleiterspeicher aktiv, wenn Normalspeicherzellen NMC (entlang einer Normalwortleitung NWL) einer beliebigen Speicherfeldblockeinheit BK (oder Redundanzspeicherzellen RMC entlang einer solchen Normalwortleitung NWL) durch Redundanzspeicherzellen RMC entlang einer Redundanzwortleitung RWL einer ebenfalls beliebigen, das heißt ggf. anderen, Speicherfeldblockeinheit BK funktionell zu ersetzen sind. Die zu ersetzenden Normalspeicherzellen NMC können also, wie nachstehend noch gezeigt wird, in der selben Speicherfeldblockeinheit BK angeordnet sein wie die ersetzenden Redundanzspeicherzellen RMC oder aber in einer anderen Speicherfeldblockeinheit BK.

Jede Speicherfeldblockeinheit BK weist erfindungsgemäß weiterhin ein Aktivierungssignal ØACT auf. Dieses ist innerhalb einer jeweiligen Speicherfeldblockeinheit BK lediglich dann in einem aktivierten Zustand, wenn aufgrund der jeweils vorliegenden Wortleitungsadressignale WLAD, des Redundanzblockdecoders RBK und der Redundanzwortleitungsdecoder RWDEC Redundanzspeicherzellen RMC entlang von Redundanzwortleitungen RWL adressiert sind zum funktionellen Ersetzen von Normalspeicherzellen NMC, wobei die zu ersetzenden Normalspeicherzellen NMC in einer beliebigen Speicherfeldblockeinheit BK angeordnet sein können, was nachstehend noch erläutert wird. Im aktivierten Zustand übernimmt das Aktivierungssignal ØACT innerhalb derjenigen Speicherfeldblockeinheit BK, in der es auftritt, die Rolle des dieser Speicherfeldblockeinheit BK normalerweise (das heißt ohne Einsatz oder Aktivieren der Redundanz) zugeordneten Blocksignals BKS, wobei es die oben beschriebene Wirkung des Inhibitsignals INHIB für diese eine Speicherfeldblockeinheit BK aufhebt.

Nachstehend wird nun die Funktion des oben beschriebenen erfindungsgemäßen Halbleiterspeichers beispielhaft beschrieben anhand von Figur 1. Dabei wird in einem ersten Fall zunächst das Auslesen von Informationen aus Normalspeicherzellen NMC beschrieben und anschließend in einem zweiten Fall das Auslesen von Informationen aus Redundanzspeicherzellen RMC, die angenommenermaßen Normalspeicherzellen NMC funktionell ersetzen sollen.

Dem Beispiel liegen folgende Annahmen zugrunde: Die links dargestellte Speicherfeldblockeinheit BK wird mit BKl bezeichnet, um sie auch bezugszeichenmäßig von der rechten Speicherfeldblockeinheit BK unterscheiden zu können, welche mit BKn bezeichnet wird. Die im Beispiel an den Halbleiterspeicher anzulegende Kombination von Wortleitungsadressignalen WLAD diene dazu, um Normalspeicherzellen NMC in der linken Speicherfeldblockeinheit BKl zu adressieren im ersten Fall, in dem diese Normalspeicherzellen NMC nicht durch Redundanzspeicherzellen RMC zu ersetzen sind.

Im anderen, zweiten Fall, wird eine Kombination von Wortleitungsadressignalen WLAD an den Halbleiterspeicher angelegt, bei der die dieser Kombination entsprechenden Normalspeicherzellen NMC, die angenommenermaßen ebenfalls in der linken Speicherfeldblockeinheit BKl angeordnet sein sollen, durch entsprechende Redundanzspeicherzellen RMC ersetzt werden. Bei den eingangs genannten Redundanz-Architekturen nach dem Stand der Technik müßten diese Redundanzspeicherzellen RMC wegen der Anordnung der Normalspeicherzellen NMC in der linken Speicherfeldblockeinheit BKl ebenfalls zwingend in derselben, linken Speicherfeldblockeinheit BKl angeordnet sein. Dies ist zwar bei der vorliegenden Erfindung auch möglich, aber nicht zwingend notwendig. Vielmehr können diese Redundanzspeicherzellen RMC auch in einer anderen der Speicherfeldblockeinheiten BK angeordnet sein. Um dies zu zeigen, wird vorliegend eine Anordnung in der rechten Speicherfeldblockeinheit BKn angenommen.

Im ersten Fall, das heißt Auslesen von Informationen aus Normalspeicherzellen NMC in der linken Speicherfeldblockeinheit BKl, ist naturgemäß keiner der Redundanzwortleitungsdecoder RWDEC und keiner der Redundanzblockdecoder RBK so programmiert, daß dies zu einem Ersetzen der Normalspeicherzellen NMC durch Redundanzspeicherzellen RMC führt. Bei Anlegen der gewählten Kombination von Wortleitungsadressignalen WLAD und des Taktsignals $\overline{RAS}$ werden die Wortleitungsadressignale WLAD in den Wortleitungsadreßpuffer WLADBF übernommen und dort in ihrer wahren (WLAD) und in ihrer komplementären Form ($\overline{WLAD}$) zwischengespeichert, wie allgemein bekannt.

Der erste Teil BKAD der so zwischengespeicherten Wortleitungsadressignale WLAD, $\overline{WLAD}$ wird dem Blockdeco-

der BKDEC zugeführt. Dieser erzeugt das für die linke Speicherfeldblockeinheit BKl zuständige Blockauswahlsignal BKSl, welches die linke Speicherfeldblockeinheit BKl auswählt und aktiviert. Die restlichen Blockauswahlsignale BKS, zuständig für die restlichen Speicherfeldblockeinheiten BK einschließlich der rechten Speicherfeldblockeinheit BKn mit zugehörigem Blockauswahlsignal BKSn bleiben inaktiv, das heißt in nicht-ausgewähltem Zustand, wodurch die restlichen Speicherfeldblockeinheiten weder ausgewählt noch aktiviert werden.

Der zweite Teil der zwischengespeicherten Wortleitungsadressignale WLAD, $\overline{\text{WLAD}}$ wird an die Normalwortleitungsdecoder NWDEC aller Speicherfeldblockeinheiten BK angelegt. Allerdings wählt nur der in der linken Speicherfeldblockeinheit BKl enthaltene Normalwortleitungsdecoder NWDEC (aufgrund des zweiten Teils WL2AD der Wortleitungsadressignale WLAD) die der an den Halbleiterspeicher angelegten Kombination der Wortleitungsadressignale WLAD entsprechende Normalwortleitung NWL aus, da nur das Blockauswahlsignal BKSl der linken Speicherfeldblockeinheit BKl aktiviert ist. Die Normalwortleitungsdecoder NWDEC der restlichen Speicherfeldblockeinheiten BK (einschließlich BKn) bleiben inaktiv, da deren Blockauswahlsignale BKS (einschließlich BKSn) aufgrund des ersten Teils BKAD der Wortleitungsadressignale WLAD inaktiv sind.

Das Blockauswahlsignal BKSl hat in der linken Speicherfeldblockeinheit BKl ferner die Wirkung, alle zur Funktion der linken Speicherfeldblockeinheit BKl notwendigen Signale mittels der Aktivierungseinrichtung ACT zu erzeugen und zu aktivieren, um die linke Speicherfeldblockeinheit BKl auch betreiben zu können (z.B. Durchführen des Precharge-Vorganges auf den Bitleitungen, Aktivieren der Leseverstärker SA etc.). Das Adressieren der Normalbitleitungen NBL, $\overline{\text{NBL}}$ bzw. ggf. der Redundanzbitleitungen RBL, $\overline{\text{RBL}}$ erfolgt wie beim Stand der Technik über Bitleitungsadreßpuffer BLADBF, Bitleitungsadressignale BLAD, $\overline{\text{BLAD}}$, Taktsignal $\overline{\text{CAS}}$, Normalbitleitungsdecoder NBDEC bzw. ggf. Redundanzbitleitungsdecoder RBDEC (zur Adressierung von solchen Redundanzspeicherzellen RMC entlang von Redundanzbitleitungen RBL, RBL, die gleichzeitig auch entlang der Normalwortleitungen NWL angeordnet sind, was vorliegend jedoch unbeeinflußt ist von der erfindungsgemäßen Redundanzkonzeption).

Auf diese Art und Weise sind also beispielsweise Informationen aus Speicherzellen (NMC, ggf. RMC) entlang der adressierten Normalwortleitung NWL auslesbar, bewertbar, verstärkbar und auf einen vorhandenen Datenbus XB, XB gebbar zur Weiterleitung beispielsweise an einen Datenausgangsanschluß DO des Halbleiterspeichers.

Im zweiten Fall wird eine Kombination von Wortleitungsadressignalen WLAD und Bitleitungsadressignalen BLAD an den Halbleiterspeicher angelegt, mittels der im Normalfall, das heißt, wenn keine Redundanzwortleitung RWL auszuwählen wäre, ebenfalls eine Normalwortleitung NWL in der linken Speicherfeldblockeinheit BKl ausgewählt würde. Die Bitleitungsdecodierung und -Adressierung erfolgt entsprechend dem ersten Fall. Die Wortleitungsadressierung erfolgt aufgrund der vorliegenden Erfindung im zweiten Fall wegen des vorzunehmenden Ersetzens jedoch gänzlich anders als im ersten Fall. Dazu seien im Beispiel folgende Annahmen getroffen: Entlang derjenigen Normalwortleitung NWL der linken Speicherfeldblockeinheit BKl, die im Normalfall, das heißt bei "Nichtsetzen" zu adressieren wäre, sei beispielsweise in einem früheren Testlauf wenigstens eine Normalspeicherzelle NMC als defekt erkannt worden. Deshalb sind, um den Halbleiterspeicher trotzdem ordnungsgemäß betreiben zu können, alle Speicherzellen, das heißt alle Normalspeicherzellen NMC und auch alle Redundanzspeicherzellen RMC (soweit vorhanden), die entlang dieser Normalwortleitung NWL angeordnet sind, funktionell durch eine gleiche Anzahl von Redundanzspeicherzellen RMC entlang einer Redundanzwortleitung RWL zu ersetzen. Bei den bereits genannten Redundanz-Architekturen nach dem Stand der Technik muß eine solche Redundanzwortleitung RWL in der selben Speicherfeldblockeinheit BK angeordnet sein wie die Normalwortleitung NWL, deren Speicherzellen funktionell ersetzt werden sollen. Eine derartige Anordnung ist auch beim erfindungsgemäßen Halbleiterspeicher möglich. Darüberhinaus ist es jedoch auch möglich, daß diese Redundanzwortleitung RWL in einer der restlichen Speicherfeldblockeinheiten BK angeordnet ist. Vorliegend ist nun beispielhaft angenommen, daß diese Redundanzwortleitung RWL in der rechten Speicherfeldblockeinheit BKn angeordnet sei. Um diese Redundanzwortleitung RWL in der rechten Speicherfeldblockeinheit BKn adressieren zu können, muß deshalb der Halbleiterspeicher nach Erkennen des Fehlers, jedoch vor dem noch zu schildernden Betrieb im "reparierten" Zustand (= 2. Fall), auf diesen Zustand "eingestellt" werden. Dazu wird der Redundanzblockdecoder RBK der rechten Zellenfeldblockeinheit BKn auf diejenige Kombination des ersten Teils BKAD der Wortleitungsadreßsignale WLAD, $\overline{\text{WLAD}}$ programmiert, die bei Anliegen an den Blockdecoder BKDEC das für die linke Zellenfeldblockeinheit BKl zuständige Blockauswahlsignal BKSl aktiviert. Der Redundanzblockdecoder RBK sei ein mit Fuses versehener Decoder, ähnlich den (auch bislang bereits) üblichen Redundanzdecodern. Das Programmieren erfolgt durch Unterbrechen (z.B. mittels Strom oder Laserstrahl) derjenigen der Fuses, aufgrund derer der Redundanzblockdecoder RBK auf die bestimmte Kombination reagiert, wenn diese angelegt wird.

Entsprechend wird auch der Redundanzwortleitungsdecoder RWDEC der rechten Speicherfeldblockeinheit BKn auf die Adresse derjenigen Normalwortleitung NWL der linken Speicherfeldblockeinheit BKl programmiert (ebenfalls über Fuses, wie allgemein bekannt), welche die zu ersetzenden Speicherzellen enthält.

Mit diesen, einmal vorzunehmenden, vorbereitenden Maßnahmen ist dann der erfindungsgemäße Halbleiterspeicher für den Betrieb im zweiten Fall bereit: Bei Anlegen der adreßspezifischen Kombination der Wortleitungsadressignale WLAD an den Halbleiterspeicher wird mittels des ersten Teils BKAD der Wortleitungsadressignale WLAD über den Blockdecoder BKDEC das für die linke Speicherfeldblockeinheit BKl zuständige Blockauswahlsignal BKSl generiert

5

(ebenso wie im ersten Fall und wie bei den Redundanz-Architekturen nach dem Stand der Technik). Gleichzeitig aktiviert jedoch (aufgrund der vorgenommenen Programmierung) der Redundanzblockdecoder RBK der rechten Speicherfeldblockeinheit BKn mittels ebenfalls des ersten Teils BKAD der Wortleitungsadressignale WLAD das Redundanzblockauswahlsignal RBKSn.

Dieses aktiviert die diesem zugeordneten Redundanzwortleitungsdecoder RWDEC, nämlich die Redundanzwortleitungsdecoder RWDEC der rechten Speicherfeldblockeinheit BKn. Daraufhin wählt derjenige der Redundanzwortleitungsdecoder RWDEC der rechten Speicherfeldblockeinheit BKn, der für die Auswahl der gewünschten Redundanzwortleitung RWL (aufgrund der vorgenommenen Programmierung) zuständig ist, die gewünschte Redundanzwortleitung RWL aus und aktiviert diese (beispielsweise über eine ihm zugeordnete Wortleitungstreiberschaltung WLDVR, die aus Gründen der Übersichtlichkeit (und da allgemein bekannt) nicht dargestellt ist.

Gleichzeitig aktiviert dieser Redundanzwortleitungsdecoder RWDEC das bereits genannte Inhibitsignal INHIB, welches allen Speicherfeldblockeinheiten BK zugeführt ist. Das Inhibitsignal INHIB dient dazu, in allen Speicherfeldblockeinheiten BK die Wirkung der Blockauswahlsignale BKS zu unterbinden, das heißt die Aktivierungseinrichtungen ACT bleiben inaktiviert. Im vorliegenden zweiten Fall wird damit also erreicht, daß das durch den Blockdecoder BKDEC aktivierte Blockauswahlsignal BKSI in der linken Speicherfeldblockeinheit BKl keine Wirkung entfalten kann (Die restlichen Blockauswahlsignale BKS sind aufgrund der für dieses Beispiel gewählten Kombination der Wortleitungsadressignale WLAD (und damit des ersten Teils BKAD der Wortleitungsadressignale WLAD) sowieso nicht aktiviert). Somit ist also im vorliegenden Beispiel (auch) die linke Speicherfeldblockeinheit BKl inaktiv.

Der in der rechten Speicherfeldblockeinheit BKn ausgewählte Redundanzwortleitungsdecoder RWDEC erzeugt weiterhin auch ein Aktivierungssignal ØACTn. Dieses Aktivierungssignal ØACTn übernimmt nun in der rechten Speicherfeldblockeinheit BKn die Rolle des für die rechte Speicherfeldblockeinheit BKn eigentlich vorgesehenen Blockauswahlsignals BKSn, das heißt die rechte Speicherfeldblockeinheit BKn wird mittels ihrer Aktivierungseinrichtung ACT aktiviert, so daß das gewünschte Auslesen der Informationen aus den zu adressierenden Redundanzspeicherzellen RMC auch tatsächlich erfolgen kann.

Die vorliegende Erfindung erlaubt es also, Normal- und Redundanzspeicherzellen NMC, RMC entlang einer Normalwortleitung NWL durch Redundanzspeicherzellen RMC entlang einer Redundanzwortleitung RWL funktionell zu ersetzen unabhängig davon, ob die für den Ersatz vorgesehenen Redundanzspeicherzellen RMC (und damit deren zugehörige Redundanzwortleitung RWL) in derselben Speicherfeldblockeinheit BK angeordnet sind wie die zu ersetzenden Speicherzellen oder ob sie in einer anderen Speicherfeldblockeinheit BK angeordnet sind. Dabei wird stets nur diejenige Speicherfeldblockeinheit BK aktiviert, in der die ersetzenden Redundanzspeicherzellen RMC physikalisch enthalten sind.

Die Ausführungsform nach Figur 2 zeigt, wie bereits erwähnt, einen integrierten Halbleiterspeicher, bei dem ein einziger programmierbarer Redundanzblockdecoder RBK vorgesehen ist, und zwar außerhalb der Speicherfeldblockeinheiten BK. Der programmierbare Redundanzblockdecoder RBK kann eine programmierbare Decodereinrichtung mit einer der Anzahl von Speicherfeldblockeinheiten BK mit Redundanzwortleitungen RWL entsprechenden Anzahl von Decodern sein. Er weist eine der Anzahl der Speicherfeldblockeinheiten BK mit Redundanzwortleitungen RWL entsprechende Anzahl von Redundanzblockauswahlsignalen RBKS auf, wobei ein jeweiliges Redundanzblockauswahlsignal RBKS mit den Redundanzwortleitungsdecodern RWDEC einer jeweiligen Speicherfeldblockeinheit BK verbunden ist. Der Redundanzblockdecoder RBK ist so programmierbar, daß jeweils eines oder mehrere seiner Redundanzblockauswahlsignale RBKS aktiviert ist, wenn es aufgrund der vorgenommenen Programmierung und der im Einzelfall anliegenden Kombination von Signalen des ersten Teils BKAD der Wortleitungsadressignale WLAD möglich erscheint, daß Redundanzspeicherzellen RMC zu adressieren sind. Ob tatsächlich Redundanzspeicherzellen RMC zu adressieren sind, hängt dann davon ab, welche Kombination von Signalen des zweiten Teils WL2AD der Wortleitungsadressignale WLAD an den Halbleiterspeicher, und damit an die Redundanzwortleitungsdecoder RWDEC der Speicherfeldblockeinheiten BK angelegt wird. In einem solchen Fall wird dann diejenige Speicherfeldblockeinheit BK mittels ihrer Aktivierungseinrichtung ACT aktiviert, innerhalb der ein so angewählter Redundanzwortleitungsdecoder RWDEC das Aktivierungssignal ØACT aktiviert.

In einem Fall, in dem angenommenermaßen eine erste der Speicherfeldblockeinheiten BK (z.B. die linke Speicherfeldblockeinheit BKl) mehrere Normalwortleitungen NWL enthält, deren Normalspeicherzellen NMC zu ersetzen sind, und in dem die entsprechenden, für den Ersatz vorgesehenen Redundanzwortleitungen RWL in mehr als einer Speicherfeldblockeinheit BK angeordnet sind, sind mehrere Decodereinrichtungen des einen programmierbaren Redundanzblockdecoders RBK auf dieselbe Kombination von Signalen des ersten Teils BKAD der Wortleitungsadressignale WLAD zu programmieren, nämlich auf die der linken Speicherfeldblockeinheit BKl entsprechende Kombination. Bei Anlegen der Wortleitungsadressignale WLAD mit dieser Kombination ihres ersten Teils BKAD werden demzufolge auch mehrere Redundanzblockauswahlsignal RBKS aktiviert. Aufgrund der angelegten speziellen Kombination der Signale des zweiten Teils WL2AD der Wortleitungsadressignale WLAD, die einer speziellen, zu ersetzenden Normalwortleitung NWL der ersten Speicherfeldblockeinheit BK entspricht, wird jedoch nur derjenige Redundanzwortleitungsdecoder RWDEC angesprochen, der der speziellen, die Ersetzung vornehmenden Redundanzwortleitung RWL (aufgrund seiner Programmierung) entspricht. Dieser Redundanzwortleitungsdecoder RWDEC ist aber naturgemäß nur in einer der Speicherfeldblockeinheiten BK enthalten, so daß nur diese eine Speicherfeldblockeinheit BK mittels ihres Aktivierungssignals ØACT tatsächlich aktiviert wird, obwohl mehrere Redundanzblockauswahlsignale RBKS aktiviert sind. Der erfindungsgemäße Halbleiterspeicher ermöglicht also, daß bei Vorliegen von defekten Speicherzellen, die entlang mehrerer Normalwortleitungen NWL einer Speicherfeldblockeinheit BK angeordnet sind, ein funktionelles Ersetzen dieser Speicherzellen in der Form erfolgen kann, das die ersetzenden Redundanzspeicherzellen RMC samt ihren zugehörigen Redundanzwortleitungen RWL in mehreren, verschiedenen Speicherfeldblockeinheiten BK angeordnet sein können, wodurch sich eine deutliche Erhöhung der Ausbeute bei der Herstellung ergibt. Dies ist bei Halbleiterspeichern nach dem Stand der Technik nicht möglich.

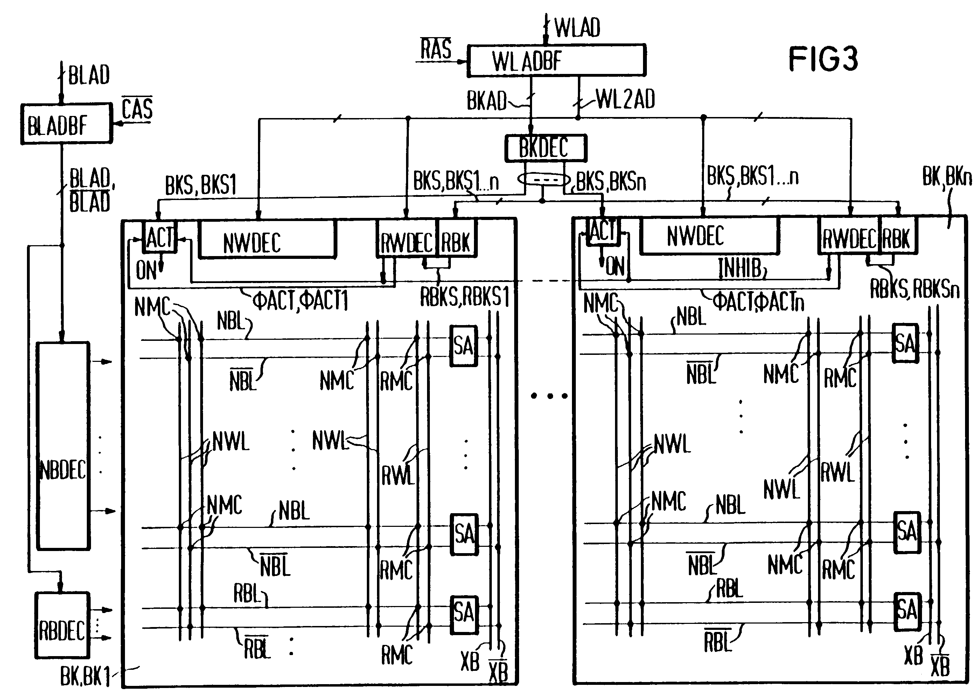

Die Ausführungsform nach Figur 3 zeigt eine der Ausführungsform nach Figur 1 ähnliche Ausgestaltung des erfindungsgemäßen Halbleiterspeichers. Es besteht jedoch folgender Unterschied: In Figur 1 werden die programmierbaren Redundanzblockdecoder RBK vom ersten Teil BKAD der Wortleitungsadressignale WLAD angesteuert. In der Ausführungsform nach Figur 3 hingegen werden stattdessen alle programmierbaren Redundanzblockdecoder RBK von allen Blockauswahlsignalen BKS angesteuert. Derjenige Redundanzblockdecoder RBK, der in derjenigen Speicherfeldblockeinheit BK angeordnet ist, die die Redundanzspeicherzellen RMC enthält, welche Speicherzellen entlang von Normalwortleitungen NWL einer beliebigen Speicherfeldblockeinheit BK ersetzen sollen, ist dann so zu programmieren, daß er denjenigen Redundanzwortleitungsdecoder RWDEC, mittels dem diejenige Redundanzwortleitung RWL auswählbar ist, entlang der die genannten Redundanzspeicherzellen RMC angeordnet sind, nur dann aktiviert , wenn von den an ihm anliegenden Blockauswahlsignalen BKS dasjenige Blockauswahlsignal BKS aktiviert ist, das im Normalfall (das heißt wenn kein Ersetzungsfall vorläge) die o.g. beliebige Speicherfeldblockeinheit BK mittels deren Aktivierungseinrichtung ACT aktivieren würde.

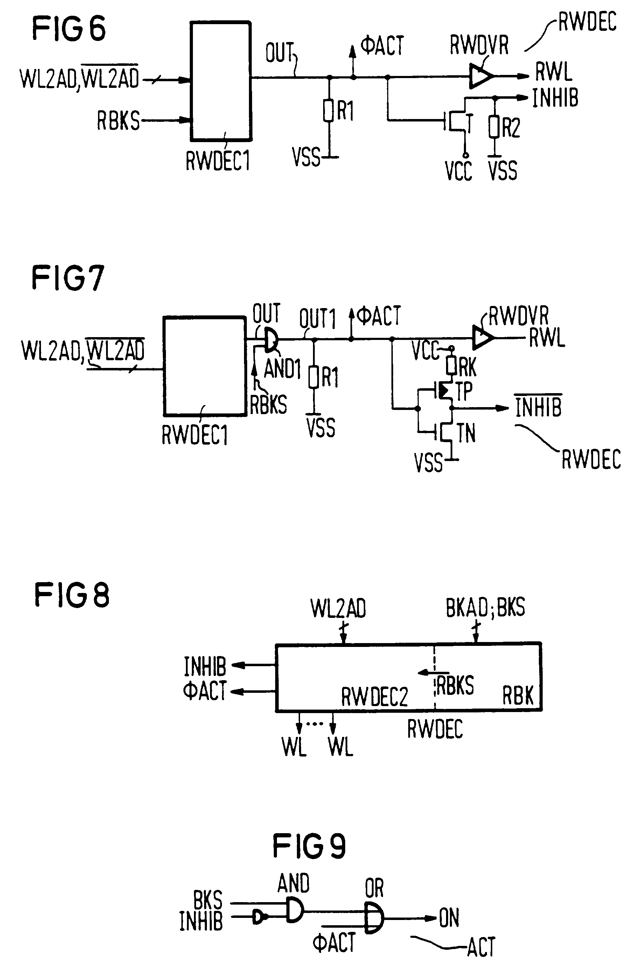

Diese Ausführungsform hat folgenden Vorteil: Wie eingangs bereits erläutert, kann eine Speicherfeldblockeinheit BK mehrere, z.B. zwei Speicherfeldblöcke aufweisen, die jeweils gemeinsam aktivierbar sind mittels eines zugehörigen Blockauswahlsignals BKS. Diese Speicherfeldblöcke einer Speicherfeldblockeinheit BK müssen auf dem Chip des Halbleiterspeichers jedoch nicht notwendigerweise physikalisch nebeneinander liegend angeordnet sein. Es ist vielmehr auch möglich, sie räumlich getrennt voneinander anzuordnen. Beispielsweise kann der eine Speicherfeldblock mit Redundanzwortleitungen RWL einer Speicherfeldblockeinheit BK entlang einem linken Rand des Chips angeordnet sein, während der andere Speicherfeldblock derselben Speicherfeldblockeinheit BK (ggf. mit weiteren Redundanzwortleitungen RWL), axialsymmetrisch zu einer gedachten Mittellinie des Chips, an einem rechten Rand des Chips angeordnet ist. Dies ist aus dem Stand der Technik bereits bekannt. In einem solchen Fall muß das für die betrachtete Speicherfeldblockeinheit BK zuständige Blockauswahlsignal BKS sowohl dem einen Speicherfeldblock wie auch dem anderen Speicherfeldblock der betrachteten Speicherfeldblockeinheit BK zugeführt werden. Dieses Blockauswahlsignal BKS muß demzufolge quer über den gesamten Halbleiterspeicherchip geführt werden (ebenfalls aus dem Stand der Technik bekannt). Kombiniert man nun einen solchen bekannten Halbleiterspeicher mit der erfindungsgemäßen Lehre, wie sie in Figur 3 ausgeführt ist, so kann man für die Redundanzblockdecoder RBK die bereits vorhandenen Leitungen der Blockauswahlsignale BKS verwenden. Man spart also, gegenüber der Ausführungsform nach Figur 1, ein zusätzliches Heranführen der Leitungen des ersten Teils BKAD der Wortleitungsadressignale WLAD. Dies gilt insbesondere dann, wenn die Redundanzblockdecoder RBK Teil der jeweiligen Redundanzwortleitungsdecoder RWDEC sind, was auch realisierbar ist (Vgl. Figur 8; wird noch beschrieben).

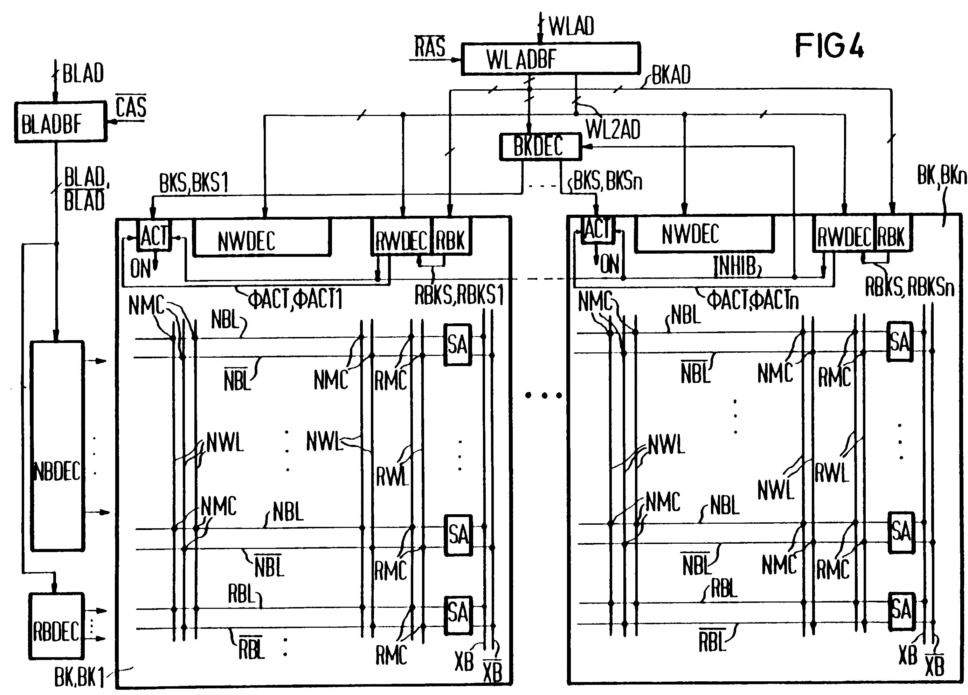

Die Ausführungsform nach Figur 4 unterscheidet sich von der nach Figur 1 dadurch, daß das Inhibitsignal INHIB zusätzlich mit dem Blockdecoder BKDEC verbunden ist. Wenn im Betrieb das Inhibitsignal INHIB durch irgendeinen der Redundanzwortleitungsdecoder RWDEC aktiviert ist, deaktiviert dieses auch den Blockdecoder BKDEC, so daß dieser keines der Blockauswahlsignale BKS aktiviert.

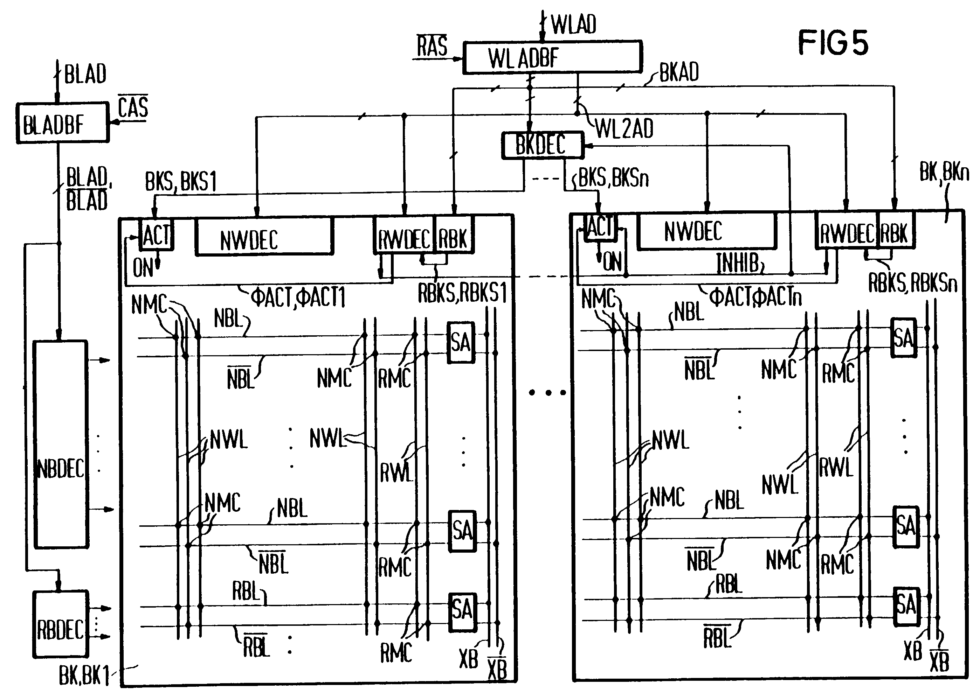

Die Ausführungsform nach Figur 5 ist eine Variante zur Ausführungsform nach Figur 4: Zwar ist hier das Inhibitsignal INHIB ebenfalls dem Blockdecoder BKDEC zugeführt mit derselben Wirkung, wie anhand von Figur 4 beschrieben. Allerdings ist in Figur 5 das Inhibitsignal INHIB (im Gegensatz zu den Ausführungsformen nach den Figuren 1 bis 4) nicht mit den Aktivierungseinrichtungen ACT verbunden, so daß diese nicht über das Inhibitsignal INHIB deaktivierbar sind. Dies ist jedoch auch nicht nötig, da sie sowieso nicht über Blockauswahlsignale BKS aktivierbar sind wegen des Einflusses des Inhibitsignales INHIB auf dem Blockdecoder BKDEC.

Figur 6 zeigt einen Redundanzwortleitungsdecoder RWDEC mit einer Einrichtung zur Erzeugung des Inhibitsignals INHIB, der zum Einsatz bei der vorliegenden Erfindung geeignet ist. Er enthält eine übliche Decodiereinrichtung RWDECI mit Eingängen für den zweiten Teil WL2AD, $\overline{\text{WL2AD}}$ der Wortleitungsadresssignale WLAD samt den bei Redundanzwortleitungsdecodern nach dem Stande der Technik üblichen Fuses (aus Gründen der Übersichtlichkeit nicht extra dargestellt), mit denen die Decodiereinrichtung RWDECI auf eine bestimmte Kombination des zweiten Teils WL2AD, $\overline{\text{WL2AD}}$ der Wortleitungsadressignale WLAD programmierbar ist. Die Decodiereinrichtung RWDECI enthält des weiteren einen Eingang für ein Redundanzblockauswahlsignal RBKS zur Aktivierung der Decodiereinrichtung RWDECI. Weist das Redundanzblockauswahlsignal RBKS einen inaktiven Zustand (z.B. log. 0) auf, so weist das Ausgangssignal OUT der Decodiereinrichtung RWDECI ebenfalls einen inaktiven Zustand (z.B. ebenfalls log. 0) auf, unabhängig davon, welche Kombination von Signalen des zweiten Teils WL2AD, $\overline{\text{WL2AD}}$ eingangsmäßig anliegt, da die Decodiereinrichtung RWDECI durch das nicht aktivierte Redundanzblockauswahlsignal RBKS inaktiv ist. Dieser Zustand liegt beim Betrieb des erfindungsgemäßen Halbleiterspeichers dann vor, wenn diejenige Speicherfeldblockeinheit BK, die den betrachteten Redundanzwortleitungsdecoder RWDEC enthält, nicht zur Auswahl einer Redundanzwortleitung RWL heranzuziehen ist (gesteuert über den ersten Teil BKAD der Wortleitungsadressignale WLAD und den zugehörigen Redundanzblockdecoder RBK). Durch geeignete, bekannte Maßnahmen kann dabei noch sichergestellt werden, daß der inaktive Zustand auch definiert eingehalten wird. In Figur 6 ist dafür ein erster Widerstand RI vorgesehen, der das Ausgangssignal OUT hochohmig mit einem Versorgungspotential, z.B. mit dem Massepotential VSS, verbindet. Das Ausgangssignal OUT ist über eine Redundanzwortleitungstreiberschaltung RWDVR mit derjenigen Redundanzwortleitung RWL verbunden, die dem betrachteten Redundanzwortleitungsdecoder RWDEC zugeordnet ist. Das Ausgangssignal OUT ist weiterhin auf das Gate eines Transistors T geführt. Die Source des Transistors T ist mit einem ein hohes Potential führenden Versorgungspotential VCC verbunden. Die Drain des Transistors T ist über einen zweiten, hochohmigen Widerstand R2 mit dem Massepotential VSS verbunden. An der Drain entsteht das Inhibitsignal INHIB. Wenn nun, wie zuvor beschrieben, das Ausgangssignal OUT inaktiv ist, ist der Transistor T gesperrt, so daß das Inhibitsignal INHIB wegen seiner hochohmigen Verbindung mit dem Massepotential VSS ebenfalls inaktiv ist. Falls allerdings irgendein anderer (als der betrachtete) Redundanzwortleitungsdecoder RWDEC des integrierten Halbleiterspeichers ausgewählt ist, so ist das Inhibitsignal INHIB aufgrund dieses anderen Redundanzwortleitungsdecoders RWDEC im aktiven Zustand. Deshalb fließt in diesem Fall ein geringer Querstrom über den zweiten Widerstand R2, was aber bei geeigneter Dimensionierung nicht stört.

Weist dagegen das Redundanzblockauswahlsignal RBKS am weiteren Eingang der Redundanzdecodiereinrichtung RWDECI einen aktiven Zustand auf (dies ist bekanntlich dann der Fall, wenn innerhalb derjenigen Speicherfeldblockeinheit BK, innerhalb der der betrachtete Wortleitungsdecoder RWDEC angeordnet ist, (irgend)eine Redundanzwortleitung RWL anzusteuern ist), so sind folgende zwei Fälle zu unterscheiden:

a) Die Redundanzdecodiereinrichtung RWDECI ist nicht auf die aktuell anliegende Kombination des zweiten Teils WL2AD der Wortleitungsadresssignale WLAD programmiert,
b) Die Redundanzdecodiereinrichtung RWDECI ist auf die aktuell anliegende Kombination des zweiten Teils WL2AD der Wortleitungsadressignale WLAD programmiert.

Im Falle a) ergibt sich kein Unterschied zur zuvor beschriebenen Funktion des gesamten Redundanzwortleitungsdecoders RWDEC samt Inhibitsignal INHIB, da die Redundanzdecodiereinrichtung RWDECI nicht auf die anliegende Kombination des zweiten Teils WL2AD der Wortleitungsadressignale WLAD anspricht.

Im Falle b) hingegen spricht die Redundanzdecodiereinrichtung RWDECI auf die genannte Kombination an. Dadurch nimmt ihr Ausgangssignal OUT den aktiven Zustand (z.B. log. 1) an. Die entsprechende Redundanzwortleitung RWL wird über den Redundanzwortleitungstreiber RWDVR ausgewählt. Gleichzeitig schaltet jedoch der Transistor T durch. Dadurch nimmt das Inhibitsignal INHIB den Wert des Versorgungspotentials VCC an, d.h. es wird aktiviert (z.B. log. 1). Der Transistor T ist dabei so zu dimensionieren, daß das Inhibitsignal INHIB seinen aktivierten Zustand sicher einnimmt auch in Anbetracht des (geringen) Querstromes, der über die zweiten Widerstände R2 der restlichen Redundanzwortleitungsdecoder RWDEC fließt. Im übrigen kann der Fachmann anhand seines Fachwissens auch querstromfreie Schaltmittel anstelle der zweiten Widerstände R2 vorsehen.

Figur 7 zeigt eine weitere Ausführungsform von Redundanzwortleitungsdecodern RWDEC. Sie unterscheidet sich von der Ausführungsform nach Figur 6 insoweit, als anstelle des Transistors T nun ein CMOS-Inverter vorgesehen ist mit Transistoren TP, TN vom zueinander entgegengesetzten Leitungstyp und als das Redundanzblockauswahlsignal RBKS nicht der Redundanzdecodiereinrichtung RWDECI zugeführt ist, sondern dieser nachgeschaltet. Dazu ist in die Leitungsführung des Ausgangssignales OUT ein AND-Gatter ANDI zwischengeschaltet mit zwei Eingängen. Der erste Eingang ist mit dem Ausgangssignal OUT verbunden, während an seinem zweiten Eingang das Redundanzblockauswahlsignal RBKS anliegt. Das Ausgangssignal OUT der Redundanzdecodiereinrichtung RWDECI wird also nur dann auf den Ausgang des AND-Gatters ANDI als geschaltetes Ausgangssignal OUTI gegeben, wenn das Redundanzblockauswahlsignal RBKS aktiviert ist. Der CMOS-Inverter ist zwischen die Versorgungspotentiale VCC, VSS geschaltet. Der Kanalbereich des Transistors TP ist dabei so zu gestalten, daß er bei durchgeschaltetem Transistor TP hochohmig ist entsprechend dem zweiten Widerstand R2 nach Figur 6, was symbolisch durch einen eingezeichneten Widerstand RK angedeutet ist. Der Transistors TN ist dagegen niederohmig auszuführen. Die Funktion des Redundanzwortleitungsdecoders RWDEC nach Figur 7 ist dieselbe wie bei Figur 6 beschrieben, allerdings ist die Polarität des Inhibitsignals INHIB gegenüber Figur 6 wegen des CMOS-Inverters umgedreht, so daß der aktivierte Zustand des Inhibitsignals INHIB jetzt dem einer logischen Null entspricht, während der inaktive Zustand dem einer logischen Eins entspricht (negative Logik, "negative going"). Das Inhibitsignal INHIB ist deshalb in Figur 7 mit "$\overline{\text{INHIB}}$ " bezeichnet.

Figur 8 zeigt eine Ausführungsform, bei der ein Redundanzwortleitungsdecoder RWDEC sowohl mehrere Redundanzwortleitungsdecodereinheiten im Sinne jeweils eines einzelnen der Redundanzwortleitungsdecoder nach den Figuren 6, 7 enthält wie auch einen programmierbaren Redundanzblockdecoder RBK. Der programmierbare Redundanzblockdecoder RBK ist also Bestandteil eines Redundanzwortleitungsdecoders RWDEC mit mehreren einzelnen Redundanzwortleitungsdecodereinheiten.

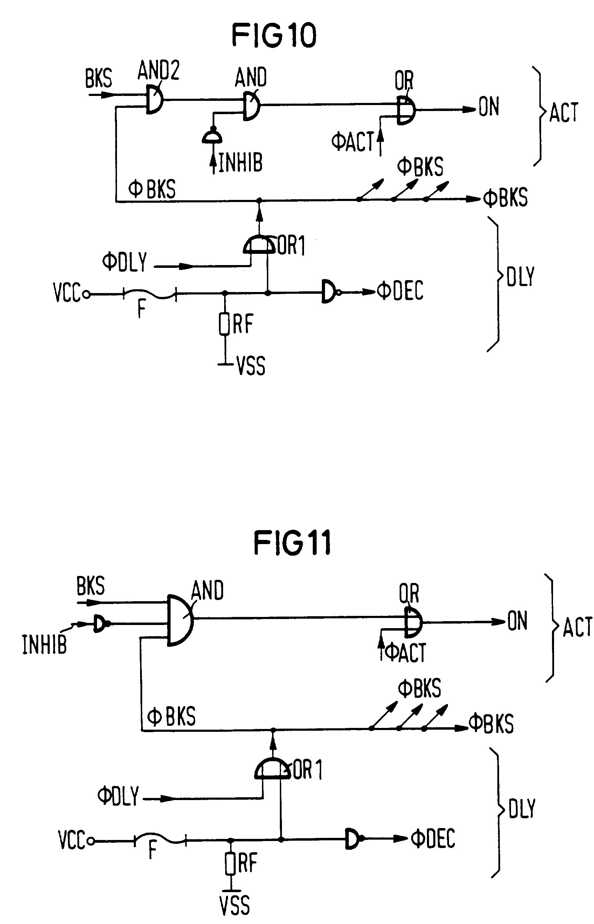

Figur 9 zeigt eine mögliche Ausführungsform der Aktivierungseinrichtung ACT einer Speicherfeldblockeinheit BK. Für ihre Funktion ist dabei wiederum positive Logik angenommen. Einem AND-Gatter AND ist an einem ersten Eingang das Blockauswahlsignal BKS zugeführt. Ein zweiter Eingang des AND-Gatters AND ist mit dem Inhibitsignal INHIB in invertierter Form beaufschlagt. Ist das Blockauswahlsignal BKS aktiviert, liegt somit am ersten Eingang ein Wert log. 1 an, ansonstens log. 0. Ist das Inhibitsignal INHIB aktiviert (das heißt log. 1), so liegt am zweiten Eingang des AND-Gatters AND der Wert log. 0 (wegen der Invertierung), ansonsten log. 1. Dies hat zur Folge, daß am Ausgang des AND-Gatters AND nur dann eine log. 1 entstehen kann, wenn gleichzeitig das Blockauswahlsignal BKS aktiviert ist (d.h. log. 1) und das Inhibitsignal INHIB deaktiviert ist (d.h. log. 0). Ansonsten entsteht eine log. 0. Der Ausgang des AND-Gatters AND ist mit einem ersten Eingang eines OR-Gatters OR verbunden. Ein zweiter Eingang des OR-Gatters OR ist mit dem Aktivierungssignal ØACT der Speicherfeldblockeinheit BK verbunden. Am Ausgang des OR-Gatters OR entsteht also das zum Aktivieren der entsprechenden Speicherfeldblockeinheit BK notwendige Signal ON in aktivierter Form demzufolge nur dann, wenn bezüglich dieser Speicherfeldblockeinheit BK einer der folgenden Fälle auftritt:

a) Es sind Speicherzellen NMC (ggf. auch RMC) entlang einer Normalwortleitung NWL zu adressieren,
b) Es sind Redundanzspeicherzellen RMC entlang einer Redundanzwortleitung RWL zu adressieren.

Im Falle a) ist das Blockauswahlsignal BKS aktiv, das Inhibitsignal INHIB und das Aktivierungssignal ØACT sind inaktiv. Im Falle b) kann zwar das Blockauswahlsignal BKS aktiv sein (wenn die zu ersetzenden Speicherzellen entlang einer Normalwortleitung NWL in der selben Speicherfeldblockeinheit BK angeordnet sind); es kann aber auch inaktiv sein (wenn die zu ersetzenden Speicherzellen entlang einer Normalwortleitung NWL einer anderen Speicherfeldblockeinheit BK angeordnet sind). Aber unabhängig davon ist das Inhibitsignal INHIB aktiviert, so daß am ersten Eingang des OR-Gatters OR ein Signal mit log. 0 anliegt. Jedoch ist das Aktivierungssignal ØACT aktiviert. In allen anderen Fällen wird die Speicherfeldblockeinheit BK aufgrund der Aktivierungseinrichtung ACT nicht aktiviert.

Erprobungen der vorliegenden Erfindung haben gezeigt, daß dieses neue Redundanzkonzept, wie vorstehend beschrieben, zwar eine deutliche Ausbeutesteigerung bei der Herstellung erfindungsgemäßer Halbleiterspeicher zur Folge hat, daß dieser Vorteil jedoch mit im Vergleich zu herkömmlichen Redundanzkonzepten höheren Zugriffszeiten erkauft wird. Zwar beträgt der Verlust an Zugriffszeit bei Ausnützen heute möglicher MOS-Halbleitertechnologien "nur" ca. 3 ns, doch bedeutet dies immerhin einen Verlust von fast 5% bei einer sonst möglichen Zugriffszeit von ca. 60 ns bei Realisierung in CMOS-Technologie. Bei Untersuchungen bezüglich dieses Verlustes an Zugriffszeit, der sich letztendlich in Form einer Verringerung der maximal möglichen Betriebsfrequenz auswirkt, hat sich gezeigt, daß der Verlust durch auftretende zusätzliche Gatter- und Signallaufzeiten verursacht ist, verglichen mit den herkömmlichen Redundanzkonzepten. Die Ursache dafür liegt in Folgendem:

Bei herkömmlichen Redundanzkonzepten leitet ein aktiviertes Blockauswahlsignal BKS mit Beginn seiner Aktivierung das Aktivieren der diesem Blockauswahlsignal BKS zugeordneten Speicherfeldblockeinheit BK ein.

Bei dem erfindungsgemäßen Redundanzkonzept hingegen, wie bislang beschrieben, darf dies so nicht erfolgen: Zwar könnte in den Fällen, in denen aufgrund von anliegenden Wortleitungsadreßsignalen WLAD keine Redundanzwortleitungen RWL auszuwählen sind, der Beginn des Aktivierens des jeweiligen Blockauswahlsignals BKS sofort zu einem Aktivieren der jeweiligen Speicherfeldblockeinheit BK führen, ohne den internen Timing-Ablauf des Halbleiterspeichers (der, im übrigen, ansonsten in der vorliegenden Beschreibung nicht angesprochen wird aus Gründen der Übersichtlichkeit und der Beschränkung auf das Wesentliche) negativ oder gar störend zu beeinflussen. Aber in der Praxis ist es jedoch so, daß zu diesem Zeitpunkt (Beginn des Aktivierens eines der Blockauswahlsignal BKS) noch gar nicht bekannt ist, ob diese aktivierte Blockauswahlsignal BKS überhaupt zu einem Aktivieren der zugehörigen Speicherfeldblockeinheit BK führen darf, oder ob nicht vielmehr die Wirkung diese aktivierten Blockauswahlsignals BKS zu unterdrücken ist (mittels des Inhibitsignals INHIB), weil aufgrund eines vorzunehmenden funktionellen Ersetzens von Speicherzellen eine andere Speicherfeldblockeinheit BK zu adressieren ist. Ob jedoch ein Ersetzen von Speicherzellen vorzunehmen ist oder nicht, steht erst zu einem Zeitpunkt fest, zu dem das Inhibitsignal INHIB spätestens aktiviert sein muß, falls es zu aktivieren ist. Dieser Zeitpunkt liegt jedoch mit Sicherheit später (vgl. den vorgenannten Betrag von 3 ns an längerer Zugriffszeit) als der (bei Nicht-Ersetzen) Zeitpunkt zum Aktivieren eines Blockauswahlsignals BKS:

Ein zu aktivierendes Blockauswahlsignal BKS benötigt (beispielsweise, dies gelte auch für die nachfolgenden Angaben bezüglich der Redundanzblockdecoder RBK) ab Übernahme der Wortleitungsadressignale WLAD in den Wortleitungsadreßpuffer WLADBF bis zu dem Zeitpunkt, wo es durch den Blockdecoder BKDEC tatsächlich aktiviert wird, eine Zeit von tl ns. Damit ist eine zu aktivierende Speicherfeldblockeinheit BK (bei Nicht-Ersetzen) nach tl ns aktivierbar.

Im Falle des Ersetzens von Speicherzellen ("Redundanzfall") übernehmen effektiv die Redundanzblockdecoder RBK die Auswahl, ob ein Redundanzwortleitungsdecoder RWDEC anzuwählen ist und, wenn dies erfolgen soll, in welcher Speicherfeldblockeinheit BK diese Anwahl durchzuführen ist (Aktivieren eines Redundanzblockauswahlsignals RBKS). Dies kann durchaus im selben Zeitraum tl geschehen wie im oben geschilderten Fall der Adressierung einer Speicherzelle entlang einer Normalwortleitung NWL, so daß dadurch allein noch keine Zeitverzögerung auftritt. Allerdings darf mit Beginn des Aktivierens eines der Redundanzblockauswahlsignale RBKS noch kein Aktivieren der zugehörigen Speicherfeldblockeinheit BK erfolgen, da zu diesem Zeitpunkt noch gar nicht feststeht, ob tatsächlich eine Redundanzwortleitung RWL anzuwählen ist. Dies steht erst nach Ablauf einer weiteren Zeitspanne t2 fest, innerhalb der ein vom aktivierten Redundanzblockauswahlsignal RBKS ausgewählter Redundanzwortleitungsdecoder RWDEC aufgrund des zweiten Teils WL2AD der an dem Halbleiterspeicher anliegenden Wortleitungsadressignale WLAD entweder tatsächlich eine Redundanzwortleitung RWL auswählt oder aber nicht (abhängig von der Programmierung des Redundanzwortleitungsdecoders RWDEC). Dann nämlich erst kann im Falle des Auswählens einer Redundanzwortleitung RWL das Inhibitsignal INHIB aktiviert werden, so daß das aktivierte Blockauswahlsignal BKS in der entsprechenden Aktivierungseinrichtung ACT unwirksam gemacht wird.

In der Praxis bedeutet dies folgendes: Einerseits muß ein aktiviertes Blockauswahlsignal BKS um einen Zeitraum t2 verzögert werden, bis feststeht, ob das Inhibitsignal INHIB aktiviert wird/ist oder nicht. Deshalb ist eine solche Verzögerung bei den bislang beschriebenen Ausführungsformen des Halbleiterspeichers im Verlauf der Blockauswahlsignale BKS notwendig, damit der Halbleiterspeicher auch unter Timing-Aspekten sicher funktioniert. Andererseits ist eine solche Verzögerung nur dann nötig, wenn bei einem jeweiligen Halbleiterspeicher überhaupt Speicherzellen durch Redundanzspeicherzellen RMC zu ersetzen sind, die in einer anderen Speicherfeldblockeinheit BK angeordnet sind als die zu ersetzenden Speicherzellen.

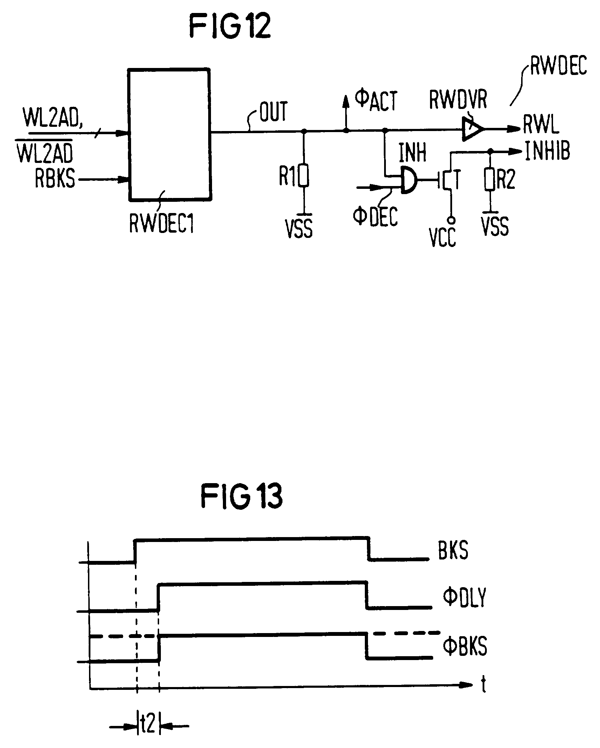

Zur Lösung dieses Problems ist nun erfindungsgemäß vorgesehen (vgl. Figuren 10, 11), daß ein erfindungsgemäßer Halbleiterspeicher, d.h. also ein Halbleiterspeicher, bei dem ersetzende Redundanzspeicherzellen RMC in einer anderen Speicherfeldblockeinheit BK angeordnet sein können als die zu ersetzenden Speicherzellen, eine programmierbare Verzögerungsschaltung DLY aufweist. Diese programmierbare Verzögerungsschaltung DLY wird (beim Herstellen und Prüfen eines entsprechenden Halbleiterspeicherbausteins) nur dann programmiert (wird noch erläutert, wie dies geschieht), wenn die Redundanzblockdecoder RBK des Halbleiterspeichers so programmiert sind bzw. werden, daß mittels der ihnen zugeordneten Redundanzwortleitungsdecoder RWDEC wenigstens eine solche Redundanzwortleitung RWL im Adressierungsfall auswählbar ist. In Weiterbildung der Erfindung wird die Verzögerungsschaltung DLY nur dann programmiert, wenn die Redundanzblockdecoder RBK des Halbleiterspeichers so programmiert sind bzw. werden, daß mittels der ihnen zugeordneten Redundanzwortleitungsdecoder RWDEC wenigstens eine solche Redundanzwortleitung RWL im Adressierungsfall auswählbar ist, die in einer anderen Speicherfeldblockeinheit BK angeordnet ist als diejenige Normalwortleitung NWL, deren zugehörige Speicherzellen zu ersetzen sind. Das Programmieren selbst kann mittels der bei Redundanzdecodern üblichen Fuse-Technik erfolgen.

Figur 10 zeigt eine mögliche Ausführungsform einer programmierbaren Verzögerungsschaltung DLY und eine der mit einer solchen programmierbaren Verzögerungsschaltung DLY verbindbaren Aktivierungseinrichtungen ACT. Die programmierbare Verzögerungsschaltung DLY enthält ein programmierbares Element F (allgemein als "Fuse" bezeichnet), welches an seinem einen Ende mit einem Potential VCC verbunden ist. Da gemäß der bisherigen Beschreibung auch hier positive Logik angenommen ist, sei das Potential VCC positiver als ein weiteres Potential VSS, welches im allgemeinen als Masse bezeichnet wird. Das programmierbare Element F ist an seinem anderen Ende mit dem weiteren Potential VSS über einen hochohmigen Widerstand RF verbunden. Das programmierbare Element F sei eine sogenannte Fuse, wie sie in der Redundanztechnik allgemein üblich ist. Im nicht-programmierten Zustand des Elementes F liegt also am anderen Ende des programmierbaren Elementes F im wesentlichen das eine Potential VCC an (wegen der Hochohmigkeit des Widerstandes RF). Im programmierten Zustand des Elementes F hingegen (d.h. das programmierbare Element F ist elektrisch unterbrochen) liegt am anderen Ende des programmierbaren Elementes F wegen des Widerstandes RF das weitere Potential VSS an. Das andere Ende des programmierbaren Elementes F ist mit dem ersten Eingang eines ODER-Gatters ORI verbunden. Ein zweiter Eingang des ODER-Gatters ORI ist mit einem Taktsignal ØDLY beaufschlagt. Eine erste Flanke des Taktsignals ØDLY ist gegenüber einem jeweiligen aktivierten Blockauswahlsignal BKS um den vorgenannten definierten Zeitraum t2 verzögert, beispielsweise um den vorgenannten Betrag von 3 ns. Am Ausgang des ODER-Gatters ORI entsteht ein Verzögerungssignal ØBKS, das jeder Aktivierungseinrichtung ACT des Halbleiterspeichers zugeführt ist.

Solange das programmierbare Element F nicht programmiert ist, weist das Verzögerungssignal ØBKS stets den Wert log. 1 auf. Ist das programmierbare Element F jedoch programmiert, so weist das Verzögerungssignal ØBKS den Verlauf des Taktsignales ØDLY auf, d.h. der Übergang von log. O auf log. 1 des Verzögerungssignals ØBKS erfolgt ebenfalls um mindestens den Zeitraum t2 verzögert. Dies ist in Fig. 13 dargestellt.

In der Ausführungsform nach Figur 10 enthalten die Aktivierungseinrichtungen ACT über die aus Figur 9 bekannten Elemente hinaus noch ein weiteres UND-Gatter AND2 mit zwei Eingängen. Der eine Eingang ist mit dem der jeweiligen Aktivierungseinrichtung ACT zugeordneten Blockauswahlsignal BKS verbunden. Der andere Eingang ist mit dem Verzögerungssignal ØBKS beaufschlagt. Während die UND-Gatter AND der Aktivierungseinrichtungen ACT nach Figur 9 an ihrem einen Eingang mit dem jeweiligen Blockauswahlsignal BKS beaufschlagt sind, ist bei den Aktivierungseinrichtungen nach Figur 10 dieser Eingang mit dem Ausgang des jeweiligen weiteren UND-Gatters AND2 verbunden. Darüberhinaus unterscheiden sich die Aktivierungseinrichtungen ACT nach Figur 10 nicht von denen nach Figur 9.

In einem ersten Programmierungsfall, in dem das programmierbare Element F dann zu programmieren ist, wenn wenigstens einer der Redundanzwortleitungsdecoder RWDEC samt zugehörigem Redundanzblockdecoder RBK zu programmieren ist, um bei Anlegen einer geeigneten Kombination von Wortleitungsadressignalen WLAD an den Halbleiterspeicher eine Redundanzwortleitung RWL auszuwählen (unabhängig davon, ob die auszuwählende Redundanzwortleitung RWL in der selben Speicherfeldblockeinheit BK angeordnet ist wie diejenige Normalwortleitung NWL, deren zugehörige Speicherzellen zu ersetzen sind), wird im programmierten Zustand des programmierbaren Elementes F ein jeweils aktiviertes Blockauswahlsignal BKS in der jeweiligen Aktivierungseinrichtung ACT mittels des Verzögerungssignals ØBKS verzögert weitergegeben zum AND-Gatter AND und, abhängig vom Zustand des Inhibitsignals INHIB, zum Aktivieren der der Aktivierungseinrichtung ACT zugehörigen Speicherfeldblockeinheit BK. Im nicht-programmierten Zustand des programmierbaren Elementes F hingegen wird ein jeweils aktiviertes Blockauswahlsignal BKS entsprechend unverzögert weitergegeben.

In einem zweiten Programmierungsfall, in dem (im Gegensatz zum ersten Programmierungsfall) das programmierbare Element F nur dann zu programmieren ist, wenn wenigstens einer der Redundanzwortleitungsdecoder RWDEC samt zugehörigem Redundanzblockdecoder RBK so zu programmieren ist, daß bei Anlegen einer geeigneten Kombination von Wortleitungsadressignalen WLAD an den Halbleiterspeicher eine Redundanzwortleitung RWL auszuwählen, die in einer anderen Speicherfeldblockeinheit BK angeordnet ist wie diejenige Normalwortleitung NWL, deren zugehörige Speicherzellen zu ersetzen sind, ist gemäß Figur 12 erfindungsgemäß noch vorgesehen, daß jeder der Redundanzwortleitungsdecoder RWDEC, beispielsweise ein solcher, wie in Figur 6 dargestellt, ein UND-Gatter INH aufweist mit zwei Eingängen. Der eine Eingang ist mit dem Ausgangssignal OUT der Decodiereinrichtung RWDECI beaufschlagt. Der andere Eingang ist über einen Inventor mit dem anderen Ende des programmierbaren Elementes F der Verzögerungsschaltung DLY verbunden (Signal ØDEC in Fig. 11). Der Ausgang des UND-Gatters INH ist mit dem Gate des Transistors T verbunden. Mit dieser Anordnung ist also das Inhibitsignal INHIB nur dann aktivierbar, wenn zum einen ein jeweiliger Redundanzwortleitungsdecoder RWDEC eine Redundanzwortleitung RWL anwählt (Ausgangssignal OUT der jeweiligen Decodiereinrichtung RWDECI ist aktiviert) und wenn das programmierbare Element F programmiert ist. Somit ist es also im betrachteten zweiten Fall (siehe oben) möglich, daß bei einem Halbleiterspeicher, dessen Redundanzblockdecoder RBK und Redundanzwortleitungsdecoder RWDEC entweder überhaupt nicht programmiert sind oder daß sie so programmiert sind, daß Redundanzwortleitungen RWL mit ersetzenden Redundanzspeicherzellen RMC ausschließlich in der jeweils selben Speicherfeldblockeinheit BK angeordnet sind wie die jeweiligen Normalwortleitungen NBL mit den zu ersetzenden Speicherzellen (d.h. das programmierbare Element F ist nicht zu programmieren im zweiten Fall), eine jeweils zu aktivierende Speicherfeldblockeinheit BK mittels ihrer Aktivierungseinrichtung ACT mit Auftreten ihres aktivierten Blockauswahlsignals BKS ohne Verzögerung aktivierbar ist, während ansonsten (d. h. das progrmmierbare Element F ist programmiert) ein Aktivieren nur verzögert erfolgen kann, da das Verzögerungssignal ØBKS aufgrund des Einflusses des Taktsignals ØDLY in den Aktivierungseinrichtungen ACT, z.B. nach Figur 10 wirksam wird.

Die Ausführungsform einer Aktivierungseinrichtung ACT nach Figur 11 unterscheidet sich insoweit von der nach Figur 10, als die beiden UND-Gatter AND und AND2 nach Figur 10 in Figur 11 zu einem einzigen UND-Gatter AND mit drei Eingängen zusammengefaßt sind. Der eine Eingang ist mit dem jeweiligen Blockauswahlsignal BKS verbunden. Der andere Eingang ist über einen Inverter mit dem Inhibitsignal INHIB verbunden. Der dritte Eingang ist mit dem Verzögerungssignal ØBKS verbunden. Funktionell besteht kein Unterschied zu der Ausführungsform nach Figur 10.

**Patentansprüche**

1.  Integrierter Halbleiterspeicher mit Redundanzeinrichtung, der folgende Merkmale aufweist:

    -   Normalspeicherzellen (NMC), die in mehreren, über zugehörige Aktivierungseinrichtungen (ACT) einzeln aktivierbaren Speicherfeldblockeinheiten (BK) angeordnet sind,
    -   Die Speicherfeldblockeinheiten (BK) sind über ihre Aktivierungseinrichtungen (ACT) mittels Blockauswahlsignalen (BKS) aktiverbar, wobei die Blockauswahlsignale (BKS) durch Blockdecoder (BKDEC) aus einem ersten Teil (BKAD) von an den Halbleiterspeicher anlegbaren Wortleitungsadressignalen (WLAD) erzeugbar sind,
    -   die Normalspeicherzellen (NMC) sind je Speicherfeldblockeinheit (BK) über Normalwortleitungen (NWL) und Normalbitleitungen (NBL, $\overline{\text{NBL}}$ ) adressierbar,
    -   Normalwortleitungsdecoder (NWDEC) zur Auswahl einer Normalwortleitung (NWL) in einer Speicherfeldblockeinheit (BK) in Abhängigkeit von einem zweiten Teil (WL2AD) der Wortleitungsadressignale (WLAD) unter Steuerung durch das der jeweiligen Speicherfeldblockeinheit (BK) zugeordnete Blockauswahlsignal (BKS),
    -   Bitleitungsdecoder (BDEC) zur Auswahl einer Normalbitleitung (NBL, $\overline{\text{NBL}}$ ) in Abhängigkeit von an den Halbleiterspeicher anlegbaren Bitleitungsadressignalen (BLAD),
    -   Redundanzspeicherzellen (RMC) in den Speicherfeldblockeinheiten (BK) entlang von Redundanzwortleitungen (RWL),

- programmierbare Redundanzwortleitungsdecoder (RWDEC) in den Speicherfeldblockeinheiten (BK) zur Auswahl einer Redundanzwortleitung (RWL) in Abhängigkeit vom zweiten Teil (WL2AD) der Wortleitungsadressignale (WLAD) in dem Fall, in dem aufgrund einer durchgeführten Programmierung eines Redundanzwortleitungsdecoders (RWDEC) über eine jeweilige Redundanzwortleitung (RWL) adressierbare Redundanzspeicherzellen (RMC) Speicherzellen entlang von Normalwortleitungen (NWL) funktionell ersetzen sollen,

**gekennzeichnet durch** wenigstens einen programmierbaren Redundanzblockdecoder (RBK) zur Auswahl von Redundanzwortleitungsdecodern (RWDEC) sowohl in solchen Fällen, in denen eine auszuwählende Redundanzwortleitung (RWL) mit ersetzenden Redundanzspeicherzellen (RMC) in der selben Speicherfeldblockeinheit (BK) angeordnet ist wie die Normalwortleitung (NWL) mit den zu ersetzenden Speicherzellen als auch in solchen Fällen, in denen eine auszuwählende Redundanzwortleitung (RWL) mit ersetzenden Redundanzspeicherzellen (RMC) in einer beliebigen anderen Speicherfeldblockeinheit (BK) angeordnet ist als die Normalwortleitung (NWL) mit den zu ersetzenden Speicherzellen.

2. Integrierter Halbleiterspeicher nach Anspruch 1,

   **dadurch gekennzeichnet,**
   daß der wenigstens eine programmierbare Redundanzblockdecoder (RBK) eingangsmäßig mit dem ersten Teil (BKAD) der Wortleitungsadressignale (WLAD) verbunden ist und daß er im programmierten Zustand Redundanzblockauswahlsignale (RBKS) zur Ansteuerung der Redundanzwortleitungsdecoder (RWDEC) in den Speicherfeldblockeinheiten (BK) erzeugt.

3. Integrierter Halbleiterspeicher nach Anspruch 1 oder 2,

   **dadurch gekennzeichnet,**
   daß bei Vorhandensein von mehr als einem programmierbaren Redundanzblockdecoder (RBK) die programmierbaren Redundanzblockdecoder (RBK) in jeder Speicherfeldblockeinheit (BK) mit Redundanzwortleitungen (RWL) angeordnet sind.

4. Integrierter Halbleiterspeicher nach Anspruch 1,
   **dadurch gekennzeichnet**

   - daß bei Vorhandensein von mehr als einem programmierbarem Redundanzblockdecoder (RBK) die programmierbaren Redundanzblockdecoder (RBK) in den Speicherfeldblockeinheiten (BK) angeordnet sind,
   - daß die programmierbaren Redundanzblockdecoder (RBK) eingangsmäßig mit allen Blockauswahlsignalen (BKS) verbunden sind und
   - daß der programmierbare Redundanzblockdecoder (RBK) einer jeweiligen Speicherfeldblockeinheit (BK) so programmierbar ist, daß er im programmierten Zustand ausgangsmäßig auch dann ein Redundanzblockauswahlsignal (RBKS) zur Ansteuerung der Redundanzwortleitungsdecoder (RWDEC) dieser Speicherfeldblockeinheit (BK) aktiviert, wenn die zu ersetzenden Speicherzellen in einer anderen als der jeweiligen Speicherfeldblockeinheit (BK) angeordnet sind.

5. Integrierter Halbleiterspeicher nach einem der vorhergehenden Ansprüche,

   **dadurch gekennzeichnet,**
   daß ein jeweiliger, durch einen Redundanzblockdecoder (RBK) angesteuerter Redundanzwortleitungsdecoder (RWDEC) ein allen Speicherfeldblockeinheiten (BK) gemeinsames Inhibitsignal (INHIB) mit einem aktivierten Zustand erzeugt zum Inhibieren aller Aktivierungseinrichtungen (ACT) des Halbleiterspeichers in dem Fall, in dem der jeweilige Redundanzwortleitungsdecoder (RWDEC) aufgrund des zweiten Teils (WL2AD) der Wortleitungsadressignale (WLAD) eine Redundanzwortleitung (RWL) auswählt, während das Inhibitsignal (INHIB) ansonsten einen inaktiven Zustand aufweist.

6. Integrierter Halbleiterspeicher nach einem der vorhergehenden Ansprüche,

   **dadurch gekennzeichnet,**
   daß jede Speicherfeldblockeinheit (BK) ein Aktivierungssignal (ØACT) enthält,

   - welches einen aktivierten Zustand aufweist, wenn einerseits ein Redundanzwortleitungsdecoder (RWDEC) in der jeweiligen Speicherfeldblockeinheit (BK) durch das jeweilige Redundanzblockauswahlsignal (RBKS) ausgewählt ist und wenn andererseits dieser ausgewählte Redundanzwortleitungsdecoder (RWDEC) aufgrund des anliegenden zweiten Teils (WL2AD) der Wortleitungsadressignale (WLAD) eine Redundanzwortleitung (RWL) auswählt und

- welches ansonsten einen inaktiven Zustand aufweist, wobei das Aktivierungssignal (ØACT) in seinem aktivierten Zustand die Funktion des für die jeweilige Speicherfeldblockeinheit (BK) zuständigen Blockauswahlsignals (BKS) übernimmt, so daß die jeweilige Speicherfeldblockeinheit (BK) mittels ihrer Aktivierungseinrichtung (ACT) aktiviert ist trotz des aktivierten Zustandes des Inhibitsignales (INHIB).

7. Integrierter Halbleiterspeicher nach einem der vorhergehenden Ansprüche,

   **dadurch gekennzeichnet,**
   daß die programmierbaren Redundanzblockdecoder (RBK) Teil der Redundanzwortleitungsdecoder (RWDEC) sind.

8. Integrierter Halbleiterspeicher nach einem der Ansprüche 5 bis 7,

   **dadurch gekennzeichnet**,
   daß mittels des Inhibitsignals (INHIB) im aktivierten Zustand anstelle eines Deaktivierens der Aktivierungseinrichtungen (ACT) ein Deaktivieren des Blockdecoders (BKDEC) erfolgt.

9. Integrierter Halbleiterspeicher nach einem der Ansprüche 5 bis 7,

   **dadurch gekennzeichnet,**
   daß mittels des Inhibitsignales (INHIB) im inaktivierten Zustand zusätzlich zum Deaktivieren der Aktivierungseinrichtungen (ACT) auch ein Deaktivieren des Blockdecoders (BKDEC) erfolgt.

10. Integrierter Halbleiterspeicher nach einem der vorhergehenden Ansprüche,

    **dadurch gekennzeichnet,**
    daß er eine programmierbare Verzögerungsschaltung (DLY) aufweist, die im programmierten Zustand das Wirksamwerden eines aktivierten Blockauswahlsignals (BKS) einer jeweiligen Speicherfeldblockeinheit (BK) um eine vorgegebene Zeitspanne (t2) verzögert, während im nicht-programmierten Zustand keine Verzögerung erfolgt.

11. Integrierter Halbleiterspeicher nach Anspruch 10,

    **dadurch gekennzeichnet,**
    daß die Verzögerungsschaltung (DLY) im nichtprogrammierten Zustand ein Aktivieren des Inhibitsignals (INHIB) unterbindet.

12. Integrierter Halbleiterspeicher nach Anspruch 10 oder 11,

    **dadurch gekennzeichnet,**
    daß das verzögerte Wirksamwerden in der Aktivierungseinrichtung (ACT) der jeweiligen Speicherfeldblockeinheit (BK) erfolgt.

13. Integrierter Halbleiterspeicher nach Anspruch 11 oder 12,

    **dadurch gekennzeichnet,**
    daß das Unterbinden des Aktiverens des Inhibitsignals (INHIB) in den Redundanzwortleitungsdecodern (RWDEC) erfolgt.

14. Integrierter Halbleiterspeicher nach einem der Ansprüche 10 bis 13,

    **dadurch gekennzeichnet,**
    daß die Programmierbarkeit durch ein programmierbares Element (F) gegeben ist.

**15.** Integrierter Halbleiterspeicher nach einem der Ansprüche 10 bis 14,

**dadurch gekennzeichnet,**
daß die Verzögerungsschaltung (DLY) nur in dem Fall programmiert ist, in dem aufgrund einer vorgenommenen Programmierung irgendeiner der Redundanzblockdecoder (RBK) und irgendeiner der Redundanzwortleitungsdecoder (RWDEC) programmiert ist.

**16.** Integrierter Halbleiterspeicher nach einem der Ansprüche 10 bis 14,

**dadurch gekennzeichnet,**
daß die Verzögerungsschaltung (DLY) nur in dem Fall programmiert ist, in dem aufgrund einer vorgenommenen Programmierung wenigstens eines Redundanzwortleitungsdecoders (RWDEC) samt zugehörigem Redundanzblockdecoder (RBK) wenigstens eine Redundanzwortleitung (RWL) mit ersetzenden Redundanzspeicherzellen (RMC) in einer anderen Speicherfeldblockeinheit (BK) angeordnet ist als eine entsprechende Normalwortleitung (NWL) mit den zu ersetzenden Speicherzellen.

## Claims

1.  Integrated semiconductor memory having a redundancy device and the following features:

    -   normal memory locations (NMC), which are arranged in a plurality of main memory area block units (BK) which can be individually activated via associated activation devices (ACT),
    -   the main memory area block units (BK) can be activated via their activation devices (ACT) by means of block selection signals (BKS), it being possible to generate the block selection signals (BKS) by block decoders (BKDEC) from a first portion (BKAD) of word line address signals (WLAD) which can be applied to the semiconductor memory,
    -   the normal memory locations (NMC) can be addressed in each main memory area block unit (BK) via normal word lines (NWL) and normal bit lines (NBL, $\overline{NBL}$ ),
    -   normal word line decoders (NWDEC) for selecting a normal word line (NWL) in a main memory area block unit (BK) as a function of a second portion (WL2AD) of the word line address signals (WLAD) under control by the block selection signal (BKS) assigned to the respective main memory area block unit (BK),
    -   bit line decoders (BDEC) for selecting a normal bit line (NBL, $\overline{NBL}$ ) as a function of bit line address signals (BLAD) which can be applied to the semiconductor memory,
    -   redundancy memory locations (RMC) in the main memory area block units (BK) along redundancy word lines (RWL),
    -   programmable redundancy word line decoders (RWDEC) in the main memory area block units (BK) for selecting a redundancy word line (RWL) as a function of the second portion (WL2AD) of the word line address signals (WLAD) in the case in which on the basis of programming that has been carried out of a redundancy word line decoder (RWDEC) redundancy memory locations (RMC) which can be addressed via a respective redundancy word line (RWL) are functionally to replace the memory locations along normal word lines (NWL), characterised in that at least one programmable redundancy block decoder (RBK) for selecting redundancy word line decoders (RWDEC) both in such cases in which a redundancy word line (RWL) having replacing redundancy memory locations (RMC) that is to be selected is arranged in the same main memory area block unit (BK) as the normal word line (NWL) having the memory cells to be replaced, and in such cases in which a redundancy word line (RWL) having replacing redundancy memory locations (RMC) that is to be selected is arranged in any other main memory area block unit (BK) than the normal word line (NWL) having the memory locations to be replaced.

2.  Integrated semiconductor memory according to Claim 1, characterised in that the at least one programmable redundancy block decoder (RBK) is connected in terms of input to the first portion (BKAD) of the word line address signals (WLAD), and in that in the programmed state it generates redundancy block selection signals (RBKS) for selecting the redundancy word line decoders (RWDEC) in the main memory area block units (BK).

3.  Integrated semiconductor memory according to Claim 1 or 2, characterised in that given the presence of more than one programmable redundancy block decoder (RBK) the programmable redundancy block decoders (RBK) are arranged in each main memory area block unit (BK) having redundancy word lines (RWL).

4.  Integrated semiconductor memory according to Claim 1, characterised in that

- given the presence of more than one programmable redundancy block decoder (RBK) the programmable redundancy block decoders (RBK) are arranged in the main memory area block units (BK),
- the programmable redundancy block decoders (RBK) are connected in terms of input to all the block selection signals (BKS), and
- the programmable redundancy block decoder (RBK) of a respective main memory area block unit (BK) can be programmed such that in the programmed state it activates a redundancy block selection signal (RBKS) in terms of output in order to select the redundancy word line decoders (RWDEC) of this main memory area block unit (BK) even if the memory locations to be replaced are arranged in a main memory area block unit (BK) other than the respective one.

5. Integrated semiconductor memory according to one of the preceding claims, characterised in that a respective redundancy word line decoder (RWDEC) selected by a redundancy block decoder (RBK) generates an inhibit signal (INHIB) with an activated state common to all the main memory area block units (BK) in order to inhibit all the activation devices (ACT) of the semiconductor memory in the case in which the respective redundancy word line decoder (RWDEC) selects a redundancy word line (RWL) on the basis of the second portion (WL2AD) of the word line address signals (WLAD), whereas the inhibit signal (INHIB) otherwise has an inactive state.

6. Integrated semiconductor memory according to one of the preceding claims, characterised in that each main memory area block unit (BK) contains an activation signal (OACT),

- which has an activated state if on the one hand a redundancy word line decoder (RWDEC) is selected in the respective main memory area block unit (BK) by the respective redundancy block selection signal (RBKS, and if on the other hand this selected redundancy word line decoder (RWDEC) selects a redundancy word line (RWL) on the basis of the applied second portion (WL2AD) of the word line address signals (WLAD), and
- which otherwise has an inactive state, the activation signal (OACT) assuming in its activated state the function of the block selection signal (BKS) responsible for the respective main memory area block unit (BK), so that the respective main memory area block unit (BK) is activated by means of its activation device (ACT) despite the activated state of the inhibit signal (INHIB).

7. Integrated semiconductor memory according to one of the preceding claims, characterised in that the programmable redundancy block decoders (RBK) are part of the redundancy word line decoders (RWDEC).

8. Integrated semiconductor memory according to one of Claims 5 to 7, characterised in that instead of deactivation of the activation devices (ACT) a deactivation of the block decoder (BKDEC) is performed by means of the inhibit signal (INHIB) in the activated state.

9. Integrated semiconductor memory according to one of Claims 5 to 7, characterised in that in addition to deactivation of the activation devices (ACT) deactivation of the block decoder (BKDEC) is also performed by means of the inhibit signal (INHIB) in the inactivated state.

10. Integrated semiconductor memory according to one of the preceding claims, characterised in that it has a programmable delay circuit (DLY) which in the programmed state delays the coming into effect of an activated block selection signal (BKS) of a respective main memory area block unit (BK) by a prescribed period (t2), while no delay takes place in the non-programmed state.

11. Integrated semiconductor memory according to Claim 10, characterised in that the delay circuit (DLY) suppresses activation of the inhibit signal (INHIB) in the non-programmed state.

12. Integrated semiconductor memory according to Claim 10 or 11, characterised in that the delayed coming into effect takes place in the activation device (ACT) of the respective main memory area block unit (BK).

13. Integrated semiconductor memory according to Claim 11 or 12, characterised in that the suppression of the activation of the inhibit signal (INHIB) takes place in the redundancy word line decoders (RWDEC).

14. Integrated semiconductor memory according to one of Claims 10 to 13, characterised in that the programmability is provided by a programmable element (F).

15. Integrated semiconductor memory according to one of Claims 10 to 14, characterised in that the delay circuit (DLY) is programmed only in the case in which any of the redundancy block decoders (RBK) and any of the redundancy word line decoders (RWDEC) is programmed on the basis of programming that has been undertaken.

16. Integrated semiconductor memory according to one of Claims 10 to 14, characterised in that the delay circuit (DLY) is programmed only in the case in which on the basis of programming that has been undertaken of at least one redundancy word line decoder (RWDEC) together with the associated redundancy block decoder (RBK) at least one redundancy word line (RWL) having replacing redundancy memory locations (RMC) is arranged in a different main memory area block unit (BK) than a corresponding normal word line (NWL) having the memory locations to be replaced.

**Revendications**

1. Mémoire intégrée à semiconducteurs comportant un dispositif à redondance qui présente les caractéristiques suivantes :

   - des cellules de mémoire normales (NMC), qui sont disposées dans plusieurs unités de blocs de zones de mémoire (BK), qui peuvent être activées individuellement par l'intermédiaire de dispositifs d'activation associés (ACT),
   - les unités de blocs de zones de mémoire (BK) peuvent être activées par l'intermédiaire de leurs dispositifs d'activation (ACT) a l'aide de signaux (BKS) de sélection de blocs, les signaux (BKS) de sélection de blocs pouvant être produits par des décodeurs de blocs (BKBEC) à partir d'une première partie (BKAD) de signaux (WLAD) d'adresses de lignes de transmission de mots, qui peuvent être appliqués à la mémoire à semiconducteurs,
   - les cellules de mémoire normales (NMC) peuvent être adressées, pour chaque unité de blocs de zones de mémoire (BK), par l'intermédiaire de lignes normales de transmission de mots (NWL) et de lignes normales de transmission de bits (NBL, $\overline{NBL}$ ),
   - des décodeurs de lignes normales de transmission de mots (NWDEC) pour la sélection d'une ligne normale de transmission de mots (NWL) dans une unité de blocs de zones de mémoire (BK), en fonction d'une seconde partie (WL2AD) des signaux (WLAD) d'adresse de ligne de transmission de mot sous la commande du signal (BKS) de sélection de bloc, qui est associé à l'unité respective de blocs de zones de mémoire (BK),

   - des décodeurs de lignes de transmission de bits (DBEC) pour la sélection d'une ligne normale de transmission de bits (NBL, $\overline{NBL}$ ) en fonction de signaux (BLAD) d'adresses de lignes de transmission de bits, qui peuvent être appliqués à la mémoire à semiconducteurs,
   - des cellules de mémoire à redondance (RMC), situées dans les unités de blocs de zones de mémoire (BK) le long de lignes (RWL) de transmission de mots à redondance,
   - des décodeurs programmables de lignes de transmission de mots à redondance (RWDEC) situées dans les unités de blocs de zones de mémoire (BK) pour la sélection d'une ligne de transmission de mots à redondance (RWL) en fonction de la seconde partie (WL2AD) des signaux d'adresses de lignes de transmission de mots (WLAD) dans le cas où, en raison d'une programmation exécutée d'un décodeur de ligne de transmission de mots à redondance (RWDEC), des cellules de mémoire à redondance (RMC), pouvant être adressées par l'intermédiaire d'une ligne respective de transmission de mots à redondence (RWL), doivent remplacer, du point de vue fonctionnel, des cellules de mémoire le long de lignes normales de transmission de mots (NWL),

   présentant la particularité suivante :
   au moins un décodeur programmable de blocs à redondance (RBK) pour la sélection de décodeurs de lignes de transmission de mots à redondance (RWDEC) aussi bien dans les cas où une ligne de transmission de mots à redondance devant être sélectionnée (RWL) comportant des cellules de mémoire à redondance (RMC) de remplacement est disposée dans la même unité de blocs de zones de mémoire (BK) que la ligne normale de transmission de mots (NWL) comportant des cellules de mémoire devant être remplacées, ainsi que dans les cas où une ligne de transmission de mots à redondance devant être sélectionnée (RWL) comportant des cellules de mémoire à redondance (RMC) de remplacement est disposée dans n'importe quelle unité de blocs de zones de mémoire (BK) autre que la ligne normale de transmission de mots (NWL) comportant les cellules de mémoire à remplacer.

**2.** Mémoire intégrée à semiconducteurs suivant la revendication 1, caractérisée par le fait que le au moins un décodeur programmable de blocs à redondance (RBK) est relié, côté entrée, à la première partie (BKAD) des signaux d'adresses de lignes de transmission de mots (WLAD) et qu'à l'état programmé, il produit des signaux de sélection de blocs à redondance (RBKS) pour la commande des décodeurs (RWDEC) de la ligne de transmission de mots à redondance dans les unités de blocs de zones de mémoire (DK).

**3.** Mémoire intégrée à semiconducteurs suivant la revendication 1 ou 2, caractérisée par le fait que dans le cas de la présence de plus d'un décodeur programmable de blocs à redondance (RBK), les décodeurs programmables de blocs à redondance (RBK) sont disposés dans chaque unité de blocs de zones de mémoire (BK) avec des lignes de transmission de mots à redondance (RWL).

**4.** Mémoire intégrée à semiconducteurs suivant la revendication 1, caractérisée par le fait

- que dans le cas de la présence de plus d'un décodeur programmable de blocs à redondance (RBK), les décodeurs programmables de blocs à redondance (RBK) sont disposés dans les unités de blocs de zones de mémoire (BK),
- que les décodeurs programmables de blocs à redondance (RBK) sont reliés, côté entrée, à tous les signaux de sélection de blocs (BKS), et
- que le décodeur programmable de blocs à redondance (RBK) d'une unité de blocs de zones de mémoire (BK) est programmable de telle sorte qu'à l'état programmé, il active alors également, côté sortie, un signal de sélection de blocs à redondance (RBKS) pour la commande des décodeurs (RWDEC) des lignes de transmission de mots à redondance de cette unité de blocs de zones de mémoire (BK), lorsque les cellules de mémoire devant être remplacées sont disposées dans une autre unité de blocs de zones de mémoire (BK) que l'unité de blocs de zones de mémoire (BK) respective.

**5.** Mémoire intégrée à semiconducteurs suivant l'une des revendications précédentes, caractérisée par le fait que chacun des décodeurs (RWDEC) de lignes de transmission de mots à redondance, qui est commandé par un décodeur de blocs à redondance (RBK), produit un signal d'inhibition (INHIB), qui est commun à toutes les unités de blocs de zones de mémoire (BK) et possède un état activé, pour bloquer tous les dispositifs d'activation (ACT) de la mémoire à semiconducteurs dans le cas où ledit décodeur (RWDEC) de la ligne de transmission de mots à redondance sélectionne, sur la base de la seconde partie (WL2AD) des signaux d'adresses de lignes de transmission de mots (WLAD), une ligne de transmission de mots à redondance (RWL), tandis que le signal d'inhibition (INHIB) possède par ailleurs un état inactif.

**6.** Mémoire intégrée à semiconducteurs suivant l'une des revendications précédentes, caractérisée par le fait que chaque unité de blocs de zones de mémoire (BK) contient un signal d'activation ($\phi$ACT),

- qui possède un état activé, lorsque, d'une part, un décodeur (RWDEC) de lignes de transmission de mots à redondance et situé dans l'unité respective de blocs de zones de mémoire (BK), est sélectionné par le signal respectif de sélection de blocs à redondance (RBKS) et que, d'autre part, ce décodeur sélectionné de lignes de transmission de mots à redondance (RWDEC) sélectionne une ligne de transmission de mots à redondance (RWL), sur la base de la seconde partie appliquée (WL2AD) des signaux d'adresses de lignes de transmission de mots (WLAD), et
- qui, sinon, possède un effet inactif,
  le signal d'activation ($\phi$ACT) assumant, dans son état activé, le rôle du signal de sélection de bloc (BKS), qui est associé à l'unité respective de blocs de zones de mémoire (BK), de sorte que l'unité respective de blocs de zones de mémoire (BK) est activée par son dispositif d'activation (ACT), en dépit de l'état activé du signal d'inhibition (INHIB).

**7.** Mémoire intégrée à semiconducteurs suivant l'une des revendications précédentes, caractérisée par le fait que les décodeurs programmables de blocs à redondance (RBK) font partie du décodeur (RWDEC) de la ligne de transmission de mots à redondance.

**8.** Mémoire intégrée à semiconducteurs suivant l'une des revendications 5 à 7, caractérisée par le fait qu'à l'état activé, le signal d'inhibition (INHIB) provoque, à la place d'une désactivation des dispositifs d'activation (ACT), une désactivation du décodeur de blocs (BKDEC).

**9.** Mémoire intégrée à semiconducteurs suivant l'une des revendications 5 à 7, caractérisée par le fait qu'à l'état désactivé, le signal d'inhibition (INHIB) déclenche, en plus de la désactivation des dispositifs d'activation (ACT), également une désactivation du décodeur de blocs (BKDEC).

10. Mémoire intégrée à semiconducteurs suivant l'une des revendications précédentes, caractérisée par le fait qu'il comporte un circuit à retard programmable (DLY), qui, à l'état programmé, retarde l'activation d'un signal activé de sélection de blocs (BKS) d'une unité respective de blocs de zones de mémoire (BK), et ce d'un intervalle de temps prédéterminé (t2), lorsqu'à l'état non programmé, il ne se produit aucun retard.

11. Mémoire intégrée à semiconducteurs suivant la revendication 10, caractérisée par le fait que le circuit à retard (DLY) est à l'état non programmé, le circuit à retard (DLY) empêche une activation du signal d'inhibition (INHIB).

12. Mémoire intégrée à semiconducteurs suivant la revendication 10 ou 11, caractérisée par le fait que l'activation retardée s'effectue dans le dispositif d'activation (ACT) de l'unité respective à blocs de zones de mémoire (BK).

13. Mémoire intégrée à semiconducteurs suivant la revendication 11 ou 12, caractérisée par le fait que le blocage de l'activation du signal d'inhibition (INHIB) s'effectue dans les décodeurs (RWDEC) de lignes de transmission de mots à redondance.

14. Mémoire intégrée à semiconducteurs suivant l'une des revendications 10 à 13, caractérisée par le fait que la possibilité de programmation est fournie par un élément programmable (F).

15. Mémoire intégrée à semiconducteurs suivant l'une des revendications 10 à 14, caractérisée par le fait que le circuit à retard (DLY) est programmé uniquement dans le cas où, sur la base d'une programmation exécutée, l'un quelconque des décodeurs de blocs à redondance (RBK) et l'un quelconque des décodeurs (RWDEC) des lignes de transmission de mots à redondance sont programmés.

16. Mémoire intégrée à semiconducteurs suivant l'une des revendications 10 à 14, caractérisée par le fait que le circuit à retard (DLY) est programmé uniquement dans le cas où, en raison d'une programmation exécutée d'au moins d'un décodeur (RWDEC) de lignes de transmission de mots à redondance, y compris le décodeur associé de blocs à redondance (RBK), au moins une ligne de transmission de mots à redondance (RWL) comportant des cellules de mémoire à redondance (RMC) de remplacement est disposée dans une autre unité de blocs de mémoire (BK) qu'une ligne normale correspondante de transmission de mots (NWL) comportant les cellules de mémoire devant être remplacées.

FIG1

FIG2

FIG 3

FIG 4

WLAD

$\overline{RAS}$  WLADBF

BLAD

$\overline{CAS}$

BLADBF

BKAD

BLAD,
$\overline{BLAD}$

BKDEC  WL2AD

BKS,BKS1  BKS,BKSn  BK,BKn

ACT  NWDEC  RWDEC  RBK  ACT  NWDEC  RWDEC  RBK

ON  ON  $\overline{INHIB}$

22  ΦACT,ΦACT1  RBKS,RBKS1  ΦACT,ΦACTn  RBKS,RBKSn

NMC  NBL  NMC  NBL

NBDEC  $\overline{NBL}$  NMC  RMC  SA  $\overline{NBL}$  NMC  RMC  SA

NWL  NWL  NWL

RWL  RWL

NMC  NBL  NMC  NBL  NWL

$\overline{NBL}$  RMC  SA  $\overline{NBL}$  NMC  RMC  SA

RBDEC  RBL  RBL

SA  SA

$\overline{RBL}$  RMC  XB  $\overline{RBL}$  RMC  XB  $\overline{XB}$

BK,BK1

EP 0 636 258 B1

FIG 5

FIG 6

WL2AD, $\overline{WL2AD}$ →

RBKS →

RWDEC1

OUT

$\Phi$ACT

R1

VSS

RWDVR

RWDEC

RWL

INHIB

T

VCC

R2

VSS

FIG 7

WL2AD, $\overline{WL2AD}$ →

RWDEC1

OUT

AND1

RBKS

OUT1

$\Phi$ACT

R1

VSS

RWDVR

RWL

VCC

RK

TP

TN

VSS

$\overline{INHIB}$

RWDEC

FIG 8

WL2AD

BKAD; BKS

INHIB ←

$\Phi$ACT ←

RWDEC2

$\overline{RBKS}$

RBK

WL  WL

RWDEC

FIG 9

BKS

INHIB

AND

OR

$\Phi$ACT

ON

ACT

24

# FIG 10

# FIG 11

# FIG 12

# FIG 13